# EUROPEAN PATENT APPLICATION

(11) **EP 3 279 731 A1**
(43) Date of publication of application: **07.02.2018**
(21) Application number: 16772762.7
(22) Date of filing: 28.03.2016
(51) Int. Cl.: G03F 7/022

(54) **RADIATION-SENSITIVE COMPOSITION AND RESIST PATTERN FORMATION METHOD**

(30) Priority: 30.03.2015 JP 2015070125
(71) Applicant: Mitsubishi Gas Chemical Company, Inc., Tokyo 100-8324 (JP)
(72) Inventor: ECHIGO, Masatoshi, Tokyo 100-8324 (JP); TOIDA, Takumi, Hiratsuka-shi Kanagawa 254-0016 (JP); SATO, Takashi, Hiratsuka-shi Kanagawa 254-0016 (JP)
(74) Representative: Müller-Boré & Partner Patentanwälte PartG mbB
(86) International application number: PCT/JP2016/059980
(87) International publication number: WO 2016/158881

(57) **Abstract**

A radiation-sensitive composition comprising (A) a resist base material, (B) an optically active diazonaphthoquinone compound, and (C) a solvent, wherein
in the radiation-sensitive composition, the content of a solid component is 1 to 80% by mass, the content of the solvent is 20 to 99% by mass, and
the resist base material (A) is a compound represented by the formula (1):

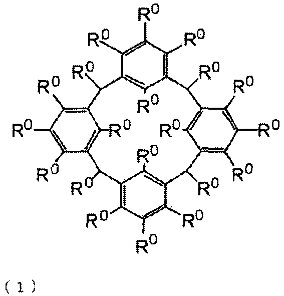

## Description

### Technical Field

The present invention relates to a radiation-sensitive composition and a method for forming a resist pattern using the composition.

### Background Art

In lithography for the production of semiconductors, LCD, or solar cells, photosensitizing agents having a quinonediazide group, such as naphthoquinonediazide compounds, and alkali soluble resins are used. Positive type photoresists having such composition exhibit high resolving power by development with an alkaline solution and are used in the production of semiconductors such as IC and LSI and the production of circuit base materials for LCD or the like.

Meanwhile, various low molecular weight resist materials have been proposed so far as resist base materials for providing a resist pattern having higher resolution for the production of leading edge semiconductors. Because of their low molecular weights, the low molecular weight resist materials are expected to provide a resist pattern having a small molecular size, high resolution, and small roughness.

For example, Patent Literature 1 has proposed an alkaline development type chemical amplification positive type radiation-sensitive composition using a low molecular weight polynuclear polyphenol compound as a main component. Patent Literature 2 has proposed an alkaline development type chemical amplification positive type radiation-sensitive composition using a low molecular weight cyclic polyphenol compound as a main component.

### Citation List

### Patent Literature

Patent Literature 1: Japanese Patent Application Laid-Open No. 2005-266741
Patent Literature 2: Japanese Patent Application Laid-Open No. 2012-83731

### Summary of Invention

### Technical Problem

However, resist patterns obtained from the radiation-sensitive compositions described in Patent Literatures 1 to 2 have large roughness. Further improvement in such radiation-sensitive compositions is desired.

The present invention has been made in light of the problems of the conventional techniques, and an object of the present invention is to provide a radiation-sensitive composition which reduces roughness and provides a good resist pattern, and a method for forming a resist pattern using the composition.

### Solution to Problem

The inventors have, as a result of devoted examinations to solve the above problems, found out that a radiation-sensitive composition comprising a resist base material represented by a specific chemical structural formula, an optically active compound, and a solvent reduces roughness and confers a good resist pattern shape, and reached the present invention.

More specifically, the present invention is as follows.
[1] A radiation-sensitive composition comprising (A) a resist base material, (B) an optically active diazonaphthoquinone compound, and (C) a solvent, wherein
   in the radiation-sensitive composition, the content of a solid component is 1 to 80% by mass, the content of the solvent is 20 to 99% by mass, and
   the resist base material (A) is a compound represented by the formula (1): 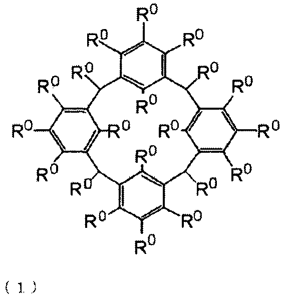 wherein R⁰ are each independently a hydrogen atom, a hydroxyl group, a cyano group, a nitro group, a heterocyclic group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, a substituted or unsubstituted aralkyl group of 7 to 30 carbon atoms, a substituted or unsubstituted alkoxy group of 1 to 20 carbon atoms, a substituted or unsubstituted amino group of 0 to 20 carbon atoms, a substituted or unsubstituted alkenyl group of 1 to 20 carbon atoms, a substituted or unsubstituted acyl group of 1 to 20 carbon atoms, a substituted or unsubstituted alkoxycarbonyl group of 2 to 20 carbon atoms, a substituted or unsubstituted alkyloyloxy group of 1 to 20 carbon atoms, a substituted or unsubstituted aryloyloxy group of 7 to 30 carbon atoms, a substituted or unsubstituted alkylsilyl group of 1 to 20 carbon atoms, or any of these groups bonded to a divalent group, wherein the divalent group is a group selected from the group consisting of a substituted or unsubstituted alkylene group, a substituted or unsubstituted arylene group, and an ether group.
[2] The radiation-sensitive composition according to [1], wherein at least one R⁰ in the compound represented by the formula (1) is a monovalent group containing an iodine atom.
[3] The radiation-sensitive composition according to [2], wherein the compound represented by the formula (1) is a compound represented by the formula (2): 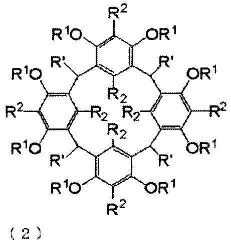 wherein R¹ are each independently a hydrogen atom, a cyano group, a nitro group, a heterocyclic group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, or a substituted or unsubstituted alkylsilyl group of 1 to 20 carbon atoms; R² are each independently a hydrogen atom, a cyano group, a nitro group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, a substituted or unsubstituted aralkyl group of 7 to 30 carbon atoms, a substituted or unsubstituted alkoxy group of 1 to 20 carbon atoms, a substituted or unsubstituted alkenyl group of 1 to 20 carbon atoms, a substituted or unsubstituted acyl group of 1 to 20 carbon atoms, a substituted or unsubstituted alkoxycarbonyl group of 2 to 20 carbon atoms, a substituted or unsubstituted alkyloyloxy group of 1 to 20 carbon atoms, a substituted or unsubstituted aryloyloxy group of 7 to 30 carbon atoms, or a substituted or unsubstituted alkylsilyl group of 1 to 20 carbon atoms; and R' are each independently a hydrogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, or a group represented by the formula (3) : 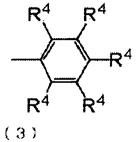 wherein R⁴ are each independently a hydrogen atom, a cyano group, a nitro group, a heterocyclic group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, a substituted or unsubstituted alkoxy group of 1 to 20 carbon atoms, or a substituted or unsubstituted alkylsilyl group of 1 to 20 carbon atoms, wherein at least one R² and/or at least one R⁴ is a monovalent group containing an iodine atom.
[4] The radiation-sensitive composition according to [3], wherein the compound represented by the formula (2) is a compound represented by the formula (4): 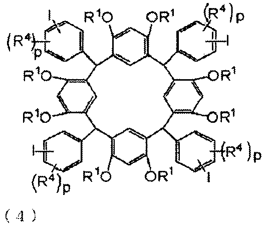 wherein R¹ and R⁴ are as defined above; and p is an integer of 0 to 4.
[5] The radiation-sensitive composition according to any of [1] to [4], wherein the solid component contains resist base material (A)/optically active diazonaphthoquinone compound (B)/optional component (D) at 1 to 99/99 to 1/0 to 98% by mass based on the solid component.
[6] The radiation-sensitive composition according to any of [1] to [5], wherein the radiation-sensitive composition is capable of forming an amorphous film by spin coating.
[7] The radiation-sensitive composition according to [6], wherein the dissolution rate of the amorphous film in a developing solution at 23°C is 5 angstrom/sec or less.
[8] The radiation-sensitive composition according to [7], wherein the dissolution rate of the amorphous film irradiated with g-ray, h-ray, i-ray, KrF excimer laser, ArF excimer laser, extreme ultraviolet, electron beam, or X-ray or the amorphous film heated at 20 to 500°C in a developing solution is 10 angstrom/sec or more.
[9] An amorphous film obtained from the radiation-sensitive composition according to any of [1] to [5].
[10] A method for forming a resist pattern, comprising the steps of:
   coating a substrate with the radiation-sensitive composition according to any of [1] to [8], thereby forming a resist film;
   exposing the resist film; and
   developing the exposed resist film.

### Advantageous Effects of Invention

The present invention can provide a radiation-sensitive composition which reduces roughness and provides a good resist pattern, and a method for forming a resist pattern using the composition.

### Description of Embodiments

Hereinafter, an embodiment of the present invention (hereinafter, referred to as "present embodiment") will be described in detail. The present embodiment is given in order to illustrate the present invention. The present invention is not limited to only the present embodiment.

### (Radiation-Sensitive Composition)

The radiation-sensitive composition of the present embodiment comprises (A) a resist base material, (B) an optically active compound, and (C) a solvent. In the radiation-sensitive composition of the present embodiment, the content of a solid component is 1 to 80% by mass, the content of the solvent is 20 to 99% by mass, and the resist base material (A) is a compound represented by the formula (1). The radiation-sensitive composition of the present embodiment having such constitution can reduce roughness and provide a good resist pattern. 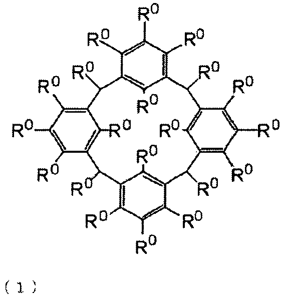 wherein R⁰ are each independently a hydrogen atom, a hydroxyl group, a cyano group, a nitro group, a heterocyclic group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, a substituted or unsubstituted aralkyl group of 7 to 30 carbon atoms, a substituted or unsubstituted alkoxy group of 1 to 20 carbon atoms, a substituted or unsubstituted amino group of 0 to 20 carbon atoms, a substituted or unsubstituted alkenyl group of 1 to 20 carbon atoms, a substituted or unsubstituted acyl group of 1 to 20 carbon atoms, a substituted or unsubstituted alkoxycarbonyl group of 2 to 20 carbon atoms, a substituted or unsubstituted alkyloyloxy group of 1 to 20 carbon atoms, a substituted or unsubstituted aryloyloxy group of 7 to 30 carbon atoms, a substituted or unsubstituted alkylsilyl group of 1 to 20 carbon atoms, or any of these groups bonded to a divalent group (one or more groups selected from the group consisting of a substituted or unsubstituted alkylene group, a substituted or unsubstituted arylene group, and an ether group).

Preferably, the radiation-sensitive composition of the present embodiment is a radiation-sensitive composition comprising 1 to 80% by mass of a solid component and 20 to 99% by mass of the solvent, and the compound represented by the formula (1) constitutes 1 to 99% by mass of the solid component. In the present specification, the "solid component" means the resist base material (A) and the optically active compound (B) contained in the radiation-sensitive composition. When the radiation-sensitive composition contains (D) an optional component mentioned later, the solid component means all of the resist base material (A), the optically active compound (B), and the optional component (D). Specifically, the content of the solid component can be confirmed by measuring the mass of the radiation-sensitive composition and the mass of a solid component remaining after removal of the solvent from the radiation-sensitive composition.

In the present specification, the term "substituted" means that one or more hydrogen atoms in a functional group are each replaced with a halogen atom, a hydroxyl group, a cyano group, a nitro group, a heterocyclic group, a linear aliphatic hydrocarbon group of 1 to 20 carbon atoms, a branched aliphatic hydrocarbon group of 3 to 20 carbon atoms, a cyclic aliphatic hydrocarbon group of 3 to 20 carbon atoms, an aryl group of 6 to 20 carbon atoms, an aralkyl group of 7 to 30 carbon atoms, an alkoxy group of 1 to 20 carbon atoms, an amino group of 0 to 20 carbon atoms, an alkenyl group of 1 to 20 carbon atoms, an acyl group of 1 to 20 carbon atoms, an alkoxycarbonyl group of 2 to 20 carbon atoms, an alkyloyloxy group of 1 to 20 carbon atoms, an aryloyloxy group of 7 to 30 carbon atoms, or an alkylsilyl group of 1 to 20 carbon atoms, unless otherwise defined.

Examples of the unsubstituted linear aliphatic hydrocarbon group of 1 to 20 carbon atoms include, but not limited to, a methyl group, an ethyl group, a propyl group, a butyl group, a pentyl group, a hexyl group, an octyl group, a decyl group, a dodecyl group, a hexadecyl group, and an octadecyl group.

Examples of the substituted linear aliphatic hydrocarbon group of 1 to 20 carbon atoms include, but not limited to, a fluoromethyl group, a 2-hydroxyethyl group, a 3-cyanopropyl group, and a 20-nitrooctadecyl group.

Examples of the unsubstituted branched aliphatic hydrocarbon group of 3 to 20 carbon atoms include, but not limited to, an isopropyl group, an isobutyl group, a tertiary butyl group, a neopentyl group, a 2-hexyl group, a 2-octyl group, a 2-decyl group, a 2-dodecyl group, a 2-hexadecyl group, and a 2-octadecyl group.

Examples of the substituted branched aliphatic hydrocarbon group of 3 to 20 carbon atoms include, but not limited to, a 1-fluoroisopropyl group and a 1-hydroxy-2-octadecyl group.

Examples of the unsubstituted cyclic aliphatic hydrocarbon group of 3 to 20 carbon atoms include, but not limited to, a cyclopropyl group, a cyclobutyl group, a cyclopentyl group, a cyclohexyl group, a cyclooctyl group, a cyclodecyl group, a cyclododecyl group, a cyclohexadecyl group, and a cyclooctadecyl group.

Examples of the substituted cyclic aliphatic hydrocarbon group of 3 to 20 carbon atoms include, but not limited to, a 2-fluorocyclopropyl group and a 4-cyanocyclohexyl group.

Examples of the unsubstituted aryl group of 6 to 20 carbon atoms include, but not limited to, a phenyl group and a naphthyl group.

Examples of the substituted aryl group of 6 to 20 carbon atoms include, but not limited to, a 4-methylphenyl group and a 6-fluoronaphthyl group.

Examples of the unsubstituted aralkyl group of 7 to 30 carbon atoms include, but not limited to, a 4-methylphenyl group, a 4-ethylphenyl group, a 6-methylnaphthyl group, and a 2,6-dimethylnaphthyl group.

Examples of the substituted aralkyl group of 7 to 30 carbon atoms include, but not limited to, a 4-fluoro-3-methylphenyl group.

Examples of the unsubstituted alkoxy group of 1 to 20 carbon atoms include, but not limited to, a methoxy group, an ethoxy group, a propoxy group, a butoxy group, a pentyloxy group, a hexyloxy group, an octyloxy group, a decyloxy group, a dodecyloxy group, a hexadecyloxy group, and an octadecyloxy group.

Examples of the substituted alkoxy group of 1 to 20 carbon atoms include, but not limited to, a chloromethoxy group and a bromoethoxy group.

Examples of the unsubstituted amino group of 0 to 20 carbon atoms include, but not limited to, an amino group, a methylamino group, a dimethylamino group, an ethylamino group, a diethylamino group, a dipropylamino group, and a dibutylamino group.

Examples of the substituted amino group of 0 to 20 carbon atoms include, but not limited to, a chloromethylamino group and a dibromomethylamino group.

Examples of the unsubstituted alkenyl group of 1 to 20 carbon atoms include, but not limited to, a vinyl group, a propynyl group, a butynyl group, a pentynyl group, a hexynyl group, an octynyl group, a decynyl group, a dodecynyl group, a hexadecynyl group, and an octadecynyl group.

Examples of the substituted alkenyl group of 1 to 20 carbon atoms include, but not limited to, a chloropropynyl group.

Examples of the unsubstituted acyl group of 1 to 20 carbon atoms include, but not limited to, a formyl group, an acetyl group, a propanoyl group, a butanoyl group, a pentanoyl group, a hexanoyl group, an octanoyl group, a decanoyl group, a dodecanoyl group, a hexadecanoyl group, and a benzoyl group.

Examples of the substituted acyl group of 1 to 20 carbon atoms include, but not limited to, a chloroacetyl group.

Examples of the unsubstituted alkoxycarbonyl group of 2 to 20 carbon atoms include, but not limited to, a methoxycarbonyl group, an ethoxycarbonyl group, a propoxycarbonyl group, a butoxycarbonyl group, a pentyloxycarbonyl group, a hexyloxycarbonyl group, an octyloxycarbonyl group, a decyloxycarbonyl group, a dodecyloxycarbonyl group, and a hexadecyloxycarbonyl group.

Examples of the substituted alkoxycarbonyl group of 2 to 20 carbon atoms include, but not limited to, a chloromethoxycarbonyl group.

Examples of the unsubstituted alkyloyloxy group of 1 to 20 carbon atoms include, but not limited to, a methoxycarbonyloxy group, an ethoxycarbonyloxy group, a propoxycarbonyloxy group, a butoxycarbonyloxy group, a pentyloxycarbonyloxy group, a hexyloxycarbonyloxy group, an octyloxycarbonyloxy group, a decyloxycarbonyloxy group, a dodecyloxycarbonyloxy group, and a hexadecyloxycarbonyloxy group.

Examples of the substituted alkyloyloxy group of 1 to 20 carbon atoms include, but not limited to, a chloromethoxycarbonyloxy group.

Examples of the unsubstituted aryloyloxy group of 7 to 30 carbon atoms include, but not limited to, a benzoyloxy group and a naphthylcarbonyloxy group.

Examples of the substituted aryloyloxy group of 7 to 30 carbon atoms include, but not limited to, a chlorobenzoyloxy group.

Examples of the unsubstituted alkylsilyl group of 1 to 20 carbon atoms include, but not limited to, a methylsilyl group, an ethylsilyl group, a propylsilyl group, a butylsilyl group, a pentylsilyl group, a hexylsilyl group, an octylsilyl group, a decylsilyl group, a dodecylsilyl group, a hexadecylsilyl group, and an octadecylsilyl group.

Examples of the substituted alkylsilyl group of 1 to 20 carbon atoms include, but not limited to, a chloromethylsilyl group.

In the present embodiment, at least one of R⁰ in the compound represented by the formula (1) is preferably a monovalent group containing an iodine atom.

Examples of the monovalent group containing an iodine atom include, but not limited to, an iodine atom, a linear aliphatic hydrocarbon group of 1 to 6 carbon atoms substituted with an iodine atom, a branched aliphatic hydrocarbon group of 3 to 6 carbon atoms substituted with an iodine atom, a cyclic aliphatic hydrocarbon group of 3 to 6 carbon atoms substituted with an iodine atom, and an aryl group of 6 carbon atoms substituted with an iodine atom.

When at least one R⁰ is a monovalent group containing an iodine atom, the iodine atom tends to increase the ability to absorb radiation such as electron beam, extreme ultraviolet (EUV), or X-ray and consequently tends to further enhance the sensitivity of the radiation-sensitive composition according to the present embodiment. Particularly, extreme ultraviolet (EUV) lithography requires higher sensitivity of radiation-sensitive compositions for improvement in the productivity of semiconductor devices. Therefore, the radiation-sensitive composition of the present embodiment as described above is particularly useful.

In the present embodiment, the compound represented by the formula (1) is more preferably a compound represented by the formula (2) from the viewpoint of a convenient production process. 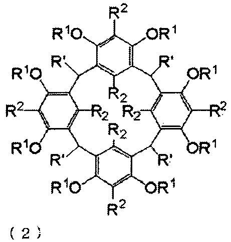 wherein R¹ are each independently a hydrogen atom, a cyano group, a nitro group, a heterocyclic group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, or a substituted or unsubstituted alkylsilyl group of 1 to 20 carbon atoms; R² are each independently a hydrogen atom, a cyano group, a nitro group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, a substituted or unsubstituted aralkyl group of 7 to 30 carbon atoms, a substituted or unsubstituted alkoxy group of 1 to 20 carbon atoms, a substituted or unsubstituted alkenyl group of 1 to 20 carbon atoms, a substituted or unsubstituted acyl group of 1 to 20 carbon atoms, a substituted or unsubstituted alkoxycarbonyl group of 2 to 20 carbon atoms, a substituted or unsubstituted alkyloyloxy group of 1 to 20 carbon atoms, a substituted or unsubstituted aryloyloxy group of 7 to 30 carbon atoms, or a substituted or unsubstituted alkylsilyl group of 1 to 20 carbon atoms; and R' are each independently a hydrogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, or a group represented by the formula (3) :
wherein R⁴ are each independently a hydrogen atom, a cyano group, a nitro group, a heterocyclic group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, a substituted or unsubstituted alkoxy group of 1 to 20 carbon atoms, or a substituted or unsubstituted alkylsilyl group of 1 to 20 carbon atoms, wherein at least one R² and/or at least one R⁴ is a monovalent group containing an iodine atom.

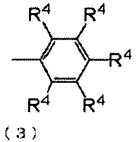

In the present embodiment, the compound represented by the formula (2) is much more preferably a compound represented by the formula (4) from the viewpoint of high sensitivity. 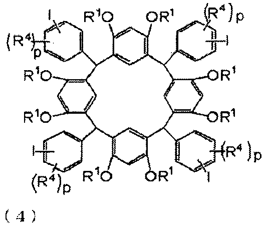 wherein R¹ and R⁴ are as defined above; and p is an integer of 0 to 4.

In the present embodiment, the compound represented by the formula (4) is further preferably a compound represented by the formula (5) from the viewpoint of high solubility. 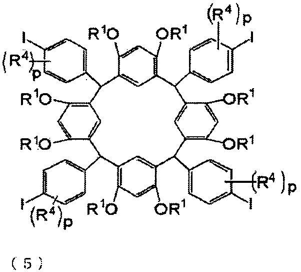 wherein R¹ and R⁴ are as defined above; and p is an integer of 0 to 4.

The compound represented by the formula (4) is still further preferably a compound represented by the formula (6) from the viewpoint of high solubility. 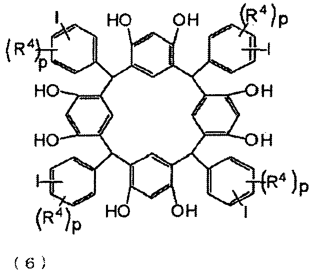 wherein R⁴ is as defined above; and p is an integer of 0 to 4.

The compound represented by the formula (5) or the formula (6) is still further preferably a compound represented by the formula (7) from the viewpoint of improvement in the roughness of a pattern shape.

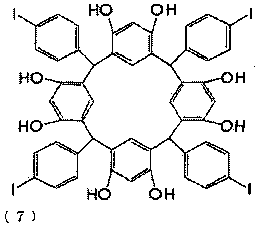

In the case of using the compound represented by the formula (7) as the resist base material (A), there is a tendency that a resist pattern that has high solubility in a safe solvent, has high sensitivity, has small roughness, and has a good shape can be formed.

The molecular weight of the compound represented by the formula (1) is not particularly limited, but is preferably 500 to 5000, more preferably 800 to 2000, and still more preferably 1000 to 2000. Within the above range, there is a tendency to improve resolution while maintaining sufficient film formability necessary for a resist.

The compound mentioned above as the resist base material (A) according to the present embodiment may assume a cis form and a trans form. The compound may be only any one of these forms or may be a mixture. Use of only any one of the cis form and the trans form is preferable because there is a tendency to increase the homogeneity of components in a resist film. The resist base material (A) constituted by only one of the cis form and the trans form can be obtained by a publicly known method such as separation by column chromatography or preparative liquid chromatography or the optimization of a reaction solvent and a reaction temperature, etc. in production.

The compound represented by the formula (1) is not limited, but can be obtained by, for example, a condensation reaction of one or more compounds selected from the group consisting of aldehydic compounds (A1) having a monovalent group containing an iodine atom with one or more compounds selected from the group consisting of phenolic compounds (A2).

In the present embodiment, preferably, the aldehydic compound (A1) is a compound of 2 to 59 carbon atoms having a monovalent group containing 1 to 4 formyl groups and an iodine atom, and the phenolic compound (A2) is a compound of 6 to 15 carbon atoms having 1 to 3 phenolic hydroxyl groups.

The above preferable aldehydic compound (A1) has 3 to 59 carbon atoms and a monovalent group containing 1 to 4 formyl groups and an iodine atom and is selected from an aromatic aldehydic compound (A1A) and an aliphatic aldehydic compound (A1B). The aromatic aldehydic compound (A1A) is preferably a benzaldehyde compound of 7 to 24 carbon atoms. Examples thereof include iodobenzaldehyde, methyliodobenzaldehyde, dimethyliodobenzaldehyde, ethyliodobenzaldehyde, propyliodobenzaldehyde, butyliodobenzaldehyde, ethylmethyliodobenzaldehyde, isopropylmethyliodobenzaldehyde, diethyliodobenzaldehyde, methoxyiodoaldehyde, iodonaphthaldehyde, iodoanthraldehyde, cyclopropyliodobenzaldehyde, cyclobutyliodobenzaldehyde, cyclopentyliodobenzaldehyde, cyclohexyliodobenzaldehyde, phenyliodobenzaldehyde, naphthyliodobenzaldehyde, adamantyliodobenzaldehyde, norbornyliodobenzaldehyde, lactyliodobenzaldehyde, isopropyliodobenzaldehyde, normal propyliodobenzaldehyde, bromoiodobenzaldehyde, dimethylaminoiodobenzaldehyde, hydroxyiodobenzaldehyde, dihydroxyiodobenzaldehyde, and trihydroxyiodobenzaldehyde. Iodobenzaldehyde, methyliodobenzaldehyde, dimethyliodobenzaldehyde, and ethyliodobenzaldehyde are more preferable, and iodobenzaldehyde is still more preferable. The aromatic aldehydic compound (A1A) may have a linear or branched alkyl group of 1 to 4 carbon atoms, a cyano group, a hydroxyl group, halogen or the like, within the range of not deteriorating the effect of the present embodiment. The aromatic aldehydic compound (A1A) may be used alone or in combination of two or more kinds.

The aliphatic aldehydic compound (A1B) is preferably a compound of 3 to 24 carbon atoms. Examples thereof include iodopropanal, iodoisopropanal, iodobutanal, iodoisobutanal, iodo-t-butanal, iodopentanal, iodoisopentanal, iodoneopentanal, iodohexanal, iodoisohexanal, iodooctanal, iododecanal, iodododecanal, iodoundecenal, iodocyclopropanecarboxyaldehyde, iodocyclobutanecarboxyaldehyde, and iodocyclohexanecarboxyaldehyde. Iodoisobutanal, iodo-t-butanal, iodopentanal, iodoisopentanal, iodoneopentanal, iodohexanal, iodoisohexanal, iodooctanal, iododecanal, iodododecanal, iodocyclopropanecarboxyaldehyde, iodocyclobutanecarboxyaldehyde, and iodocyclohexanecarboxyaldehyde are more preferable, and iodooctanal, iododecanal, iodododecanal, and iodocyclohexanecarboxyaldehyde are still more preferable. The aliphatic aldehydic compound (A1B) may have a cyano group, a hydroxyl group, halogen or the like, within the range of not deteriorating the effect of the present embodiment. The aliphatic aldehydic compound (A1B) may be used alone or in combination of two or more kinds.

The phenolic compound (A2) is preferably of 6 to 15 carbon atoms and more preferably has 1 to 3 phenolic hydroxyl groups. Preferable examples of the phenolic compound (A2) include phenol, catechol, resorcinol, hydroquinone, pyrogallol, 3-methoxyphenol, 3-ethoxyphenol, 3-cyclohexyloxyphenol, 1,3-dimethoxybenzene, 1,3-diethoxybenzene, and 1,3-dicyclohexyloxybenzene. Resorcinol, pyrogallol, 3-methoxyphenol, 3-ethoxyphenol, 3-cyclohexyloxyphenol, 1,3-dimethoxybenzene, 1,3-diethoxybenzene, and 1,3-dicyclohexyloxybenzene are more preferable, and resorcinol is still more preferable. The phenolic compound (A2) may have a linear or branched alkyl group of 1 to 4 carbon atoms, a cyano group, a hydroxyl group, halogen or the like, within the range of not deteriorating the effect of the present embodiment. The phenolic compound (A2) may be used alone or in combination of two or more kinds.

A method for producing the compound represented by the formula (1) is not particularly limited, but the compound can be produced by, for example, the following method: first, 0.1 to 10 mol of the phenolic compound (A2) is reacted with 1 mol of the aldehydic compound (A1) at 40 to 150°C for about 0.5 to 20 hours in the presence of an acid catalyst (hydrochloric acid, sulfuric acid, or p-toluenesulfonic acid, etc.) in an organic solvent such as methanol or ethanol. Subsequently, filtration, washing with an alcohol such as methanol, washing with water, and separation by filtration are conducted, followed by drying to obtain the compound represented by the formula (1) having a molecular weight of 500 to 5000. The compound represented by the formula (1) may be obtained by a similar reaction using a basic catalyst (sodium hydroxide, barium hydroxide, or 1,8-diazabicyclo[5.4.0]undecene-7, etc.) instead of the acid catalyst. Alternatively, the compound represented by the formula (1) according to the present embodiment can also be produced by converting the above aldehydic compound (A1) to a dihalide with hydrogen halide or halogen gas, and reacting the isolated dihalide with the phenolic compound (A2).

From the viewpoint of improving the solubility of the obtained compound represented by the formula (1) in a safe solvent for semiconductors, it is more preferable to use two or more kinds as at least one aldehydic compound (A1) or phenolic compound (A2).

If required, the compound represented by the formula (1) may be purified for improving its purity and reducing the amount of residual metals. From the viewpoint of securing the sufficient storage stability of the radiation-sensitive composition, it is preferable to prevent the acid catalyst and a promoter from remaining. From the viewpoint of securing the sufficient sensitivity of the radiation-sensitive composition, it is preferable to prevent the basic catalyst from remaining. Therefore, purification aimed at reducing them is preferably conducted.

The purification method can be conducted by a publicly known method as long as the resist base material is not denatured. Examples thereof include, but not particularly limited to, a method involving washing with water, a method involving washing with an acidic aqueous solution, a method involving washing with a basic aqueous solution, a method involving treatment with an ion exchange resin, and a method involving treatment by silica gel column chromatography. These purification methods are more preferably conducted in combination of two or more kinds.

The acidic aqueous solution, the basic aqueous solution, the ion exchange resin, and the silica gel column chromatography can be appropriately selected so as to be optimal according to the metals to be removed, the amounts or types of acidic and basic compounds, the types of the resist base material to be purified, etc. Examples of the acidic aqueous solution include aqueous solutions of hydrochloric acid, nitric acid, or acetic acid having a concentration of 0.01 to 10 mol/L. Examples of the basic aqueous solution include aqueous solutions of ammonia having a concentration of 0.01 to 10 mol/L. Examples of the ion exchange resin include cationic exchange resins, for example, Amberlyst 15J-HG Dry manufactured by Organo Corp.

The compound thus purified may be dried. The drying can be conducted by a publicly known method. Examples thereof include, but not particularly limited to, a method of conducting drying in vacuum or drying in hot air under conditions of not denaturing the compound represented by the formula (1).

The compound represented by the formula (1) according to the present embodiment is capable of forming an amorphous film by spin coating. Also, the compound can be applied to a general semiconductor production process.

The compound represented by the formula (1) according to the present embodiment is used in combination with the optically active diazonaphthoquinone compound (B) mentioned later and is useful as a base material for positive type resists that becomes a compound easily soluble in a developing solution by irradiation with g-ray, h-ray, i-ray, KrF excimer laser, ArF excimer laser, extreme ultraviolet, electron beam, or X-ray. Although the properties as the resist base material (A) of the compound represented by the formula (1) are not largely altered by g-ray, h-ray, i-ray, KrF excimer laser, ArF excimer laser, extreme ultraviolet, electron beam, or X-ray, the optically active diazonaphthoquinone compound (B) poorly soluble in a developing solution is converted to an easily soluble compound so that a resist pattern can be formed in a development step. Since the compound represented by the formula (1) according to the present embodiment is a low molecular weight compound, the obtained resist pattern has small roughness. In the case of using a compound represented by the formula (1) and having a monovalent group containing an iodine atom, there is a tendency to increase the ability to absorb radiation such as electron beam, extreme ultraviolet (EUV), or X-ray. As a result, the sensitivity of the radiation-sensitive composition using the resist base material according to the present embodiment can be enhanced. Thus, this is preferable.

The glass transition temperatures of the compounds represented by the formula (1) according to the present embodiment are preferably 100°C or higher, more preferably 120°C or higher, still more preferably 140°C or higher, and much more preferably 150°C or higher. When the glass transition temperatures fall within the above range, there is a tendency to have heat resistance capable of maintaining a pattern shape in a semiconductor lithography process and to improve performance such as high resolution.

The heat of crystallization determined by the differential scanning calorimetry of the glass transition temperatures of the compounds represented by the formula (1) according to the present embodiment is preferably less than 20 J/g. (Crystallization temperature) - (Glass transition temperature) is preferably 70°C or more, more preferably 80°C or more, still more preferably 100°C or more, and particularly preferably 130°C or more. When the heat of crystallization is less than 20 J/g or (Crystallization temperature) - (Glass transition temperature) falls within the above range, there is a tendency to facilitate forming an amorphous film by the spin coating of the radiation-sensitive composition and to be able to secure film formability necessary for a resist over a long period, thereby further improving resolution.

In the present embodiment, the heat of crystallization, the crystallization temperature, and the glass transition temperature can be determined by differential scanning calorimetry using DSC/TA-50WS manufactured by Shimadzu Corp. More specifically, about 10 mg of a sample is placed in a non-sealed container made of aluminum, and the temperature is raised to the melting point or higher at the rate of temperature rise of 20°C/min in a nitrogen gas stream (50 mL/min). After quenching, again the temperature is raised to the melting point or higher at the rate of temperature rise of 20°C/min in a nitrogen gas stream (30 mL/min). After further quenching, again the temperature is raised to 400°C at the rate of temperature rise of 20°C/min in a nitrogen gas stream (30 mL/min). The temperature at the middle point (where the specific heat is changed into the half) of steps in the baseline shifted in a step-like pattern is defined as the glass transition temperature (Tg). The temperature of the subsequently appearing exothermic peak is defined as the crystallization temperature. The heat is determined from the area of a region surrounded by the exothermic peak and the baseline and defined as the heat of crystallization.

The compound represented by the formula (1) according to the present embodiment is preferably low sublimable at 100°C or lower, preferably 120°C or lower, more preferably 130°C or lower, still more preferably 140°C or lower, and particularly preferably 150°C or lower at normal pressure. The low sublimability means that in thermogravimetry, weight reduction when the compounds are kept at a predetermined temperature for 10 minutes is 10%, preferably 5%, more preferably 3%, still more preferably 1%, and much more preferably 0.1% or less. There is a tendency that the low sublimability can prevent an exposure apparatus from being contaminated by outgassing upon exposure. In addition, there is a tendency that low roughness and a good pattern shape can be obtained.

The compound represented by the formula (1) according to the present embodiment is preferably dissolved at 1% by mass or more, more preferably 5% by mass or more, and still more preferably 10% by mass or more at 23°C in a solvent that is selected from propylene glycol monomethyl ether acetate (PGMEA), propylene glycol monomethyl ether (PGME), cyclohexanone (CHN), cyclopentanone (CPN), 2-heptanone, anisole, butyl acetate, ethyl propionate, and ethyl lactate and exhibits the highest ability to dissolve the compound. Much more preferably, the compound is dissolved at 20% by mass or more at 23°C in a solvent that is selected from PGMEA, PGME, and CHN and exhibits the highest ability to dissolve the compound. Further preferably, the compound is dissolved at 20% by mass or more at 23°C in PGMEA. When the above conditions are satisfied, there is a tendency to improve usefulness in a semiconductor production process in actual production.

The radiation-sensitive composition of the present embodiment comprises (B) an optically active diazonaphthoquinone compound. The optically active diazonaphthoquinone compound (B) is a diazonaphthoquinone substance comprising a polymer or non-polymer optically active diazonaphthoquinone compound and is not particularly limited as long as it is generally used as a photosensitive component in positive type resist compositions. One kind or two or more kinds can be optionally selected and used. Among them, a non-polymer optically active diazonaphthoquinone compound is preferable, and a low molecular weight compound having a molecular weight of 1500 or less, still more preferably a molecular weight of 1200 or less, and particularly preferably a molecular weight of 1000 or less is more preferable, from the viewpoint of low roughness and solubility. Preferable specific examples of such a non-polymer optically active diazonaphthoquinone compound include compounds represented by the following formulae (G), (G-1), (G-2), and (G-3).

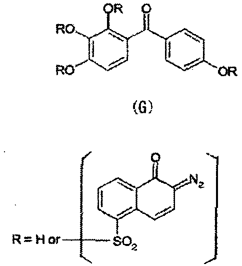

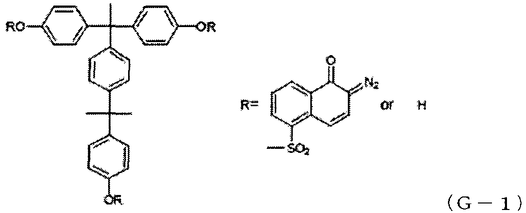

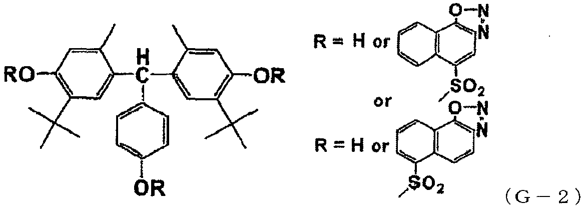

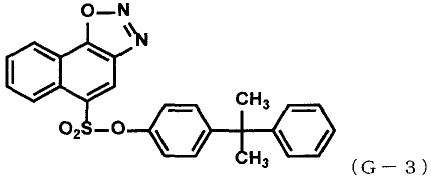

The optically active diazonaphthoquinone compound (B) is preferably a compound obtained by reacting naphthoquinonediazide sulfonic acid chloride, benzoquinonediazide sulfonic acid chloride, or the like with a low molecular weight compound or a high molecular weight compound having a functional group condensable with these acid chlorides. Herein, examples of the functional group condensable with the acid chlorides can include, but not limited to, a hydroxyl group and an amino group. Among them, a hydroxyl group is preferable. Examples of the compound containing a hydroxyl group condensable with the acid chlorides can include, but not limited to, hydroquinone, resorcin, hydroxybenzophenones such as 2,4-dihydroxybenzophenone, 2,3,4-trihydroxybenzophenone, 2,4,6-trihydroxybenzophenone, 2,4,4'-trihydroxybenzophenone, 2,3,4,4'-tetrahydroxybenzophenone, 2,2',4,4'-tetrahydroxybenzophenone, and 2,2',3,4,6'-pentahydroxybenzophenone, hydroxyphenylalkanes such as bis(2,4-dihydroxyphenyl)methane, bis(2,3,4-trihydroxyphenyl)methane, and bis(2, 4-dihydroxyphenyl)propane, and hydroxytriphenylmethanes such as 4,4',3",4"-tetrahydroxy-3,5,3',5'-tetramethyltriphenylmethane and 4,4',2",3",4"-pentahydroxy-3,5,3',5'-tetramethyltriphenylmethane.

Preferable examples of the acid chloride such as naphthoquinonediazide sulfonic acid chloride or benzoquinonediazide sulfonic acid chloride include 1,2-naphthoquinonediazide-5-sulfonyl chloride and 1,2-naphthoquinonediazide-4-sulfonyl chloride.

The radiation-sensitive composition of the present embodiment comprises (C) a solvent.

The solvent is usually prepared by dissolving each component in a solvent upon use into a homogenous solution, and then if required, filtering through a filter or the like with a pore diameter of about 0.2 µm, for example.

Examples of the solvent according to the present embodiment can include, but not particularly limited to, ethylene glycol monoalkyl ether acetates such as ethylene glycol monomethyl ether acetate, ethylene glycol monoethyl ether acetate, ethylene glycol mono-n-propyl ether acetate, and ethylene glycol mono-n-butyl ether acetate; ethylene glycol monoalkyl ethers such as ethylene glycol monomethyl ether and ethylene glycol monoethyl ether; propylene glycol monoalkyl ether acetates such as propylene glycol monomethyl ether acetate, propylene glycol monoethyl ether acetate, propylene glycol mono-n-propyl ether acetate, and propylene glycol mono-n-butyl ether acetate; propylene glycol monoalkyl ethers such as propylene glycol monomethyl ether and propylene glycol monoethyl ether; ester lactates such as methyl lactate, ethyl lactate, n-propyl lactate, n-butyl lactate, and n-amyl lactate; aliphatic carboxylic acid esters such as methyl acetate, ethyl acetate, n-propyl acetate, n-butyl acetate, n-amyl acetate, n-hexyl acetate, methyl propionate, and ethyl propionate; other esters such as methyl 3-methoxypropionate, ethyl 3-methoxypropionate, methyl 3-ethoxypropionate, ethyl 3-ethoxypropionate, methyl 3-methoxy-2-methylpropionate, 3-methoxybutylacetate, 3-methyl-3-methoxybutylacetate, butyl 3-methoxy-3-methylpropionate, butyl 3-methoxy-3-methylbutyrate, methyl acetoacetate, methyl pyruvate, and ethyl pyruvate; aromatic hydrocarbon atoms such as toluene and xylene; ketones such as 2-heptanone, 3-heptanone, 4-heptanone, cyclopentanone, and cyclohexanone; amides such as N,N-dimethylformamide, N-methylacetamide, N,N-dimethylacetamide, and N-methylpyrrolidone; and lactones such as γ-lactone. These solvents can be used alone or in combination of two or more kinds.

In the radiation-sensitive composition of the present embodiment, the content of the solid component is 1 to 80% by mass, and the content of the solvent is 20 to 99% by mass. Preferably, the content of the solid component is 1 to 50% by mass, and the content of the solvent is 50 to 99% by mass, from the viewpoint of the resolution of the resulting resist pattern. More preferably, the content of the solid component is 2 to 40% by mass, and the content of the solvent is 60 to 98% by mass. Even more preferably, the content of the solid component is 2 to 10% by mass, and the content of the solvent is 90 to 98% by mass.

The radiation-sensitive composition of the present embodiment can form an amorphous film by spin coating. Specifically, the amorphous film of the present embodiment is obtained from the radiation-sensitive composition of the present embodiment. The dissolution rate of the amorphous film formed by spin coating with the radiation-sensitive composition of the present embodiment in a developing solution at 23°C is preferably 5 angstrom/sec or less, more preferably 0.05 to 5 angstrom/sec, and still more preferably 0.0005 to 5 angstrom/sec. The amorphous film preferably has a dissolution rate of 5 angstrom/sec or less from the viewpoint of rendering a resist insoluble in a developing solution and preferably has a dissolution rate of 0.0005 angstrom/sec or more from the viewpoint of improving resolution. It is presumed that this is because due to the change in the solubility before and after exposure of the compound represented by the formula (1), contrast at the interface between the exposed portion being dissolved in a developing solution and the unexposed portion not being dissolved in a developing solution is increased. There are also reduction effects of roughness and defect.

The dissolution rate of the portion exposed by radiation such as g-ray, h-ray, i-ray, KrF excimer laser, extreme ultraviolet, electron beam, or X-ray, of the amorphous film formed by spin coating with the radiation-sensitive composition of the present embodiment, in a developing solution at 23°C is preferably 10 angstrom/sec or more, more preferably 10 to 10000 angstrom/sec, and still more preferably 100 to 1000 angstrom/sec. The exposed portion preferably has a dissolution rate of 10 angstrom/sec or more from the viewpoint of dissolving a resist in a developing solution and preferably has a dissolution rate of 10000 angstrom/sec or less from the viewpoint of improving resolution. It is presumed that this is because the micro surface portion of the compound represented by the formula (1) dissolves and roughness is reduced. There is also a reduction effect of defect. The dissolution rate of the amorphous film heated at 20 to 500°C in a developing solution is the same as above.

The content of the resist base material (A) of the present embodiment is preferably 1 to 99% by mass of the solid component (resist base material (A), optically active diazonaphthoquinone compound (B), and optional component (D)), more preferably 5 to 95% by mass, still more preferably 10 to 90% by mass, and much more preferably 25 to 75% by mass. In the case of the above content, there is a tendency to obtain a pattern having higher sensitivity and smaller roughness.

The amount of the optically active diazonaphthoquinone compound (B) of the present embodiment is preferably 1 to 99% by mass of the solid component, more preferably 5 to 95% by mass, still more preferably 10 to 90% by mass, and much more preferably 25 to 75% by mass. In the case of the above content, there is a tendency to obtain a pattern having higher sensitivity and smaller roughness.

To the radiation-sensitive composition of the present embodiment, within the range of not inhibiting the purpose of the present embodiment, if required, as the optional component (D) other than the resist base material (A), the optically active diazonaphthoquinone compound (B), and the solvent (C), one kind or two kinds or more of various additive agents such as an acid generating agent, an acid crosslinking agent, an acid diffusion controlling agent, a dissolution promoting agent, a dissolution controlling agent, a sensitizing agent, a surfactant, and an organic carboxylic acid or an oxo acid of phosphor, or derivative thereof can be added.

### (1) Acid Generating Agent

The radiation-sensitive composition of the present embodiment preferably contains one or more acid generating agents generating an acid directly or indirectly by irradiation of any radiation selected from visible light, ultraviolet, excimer laser, electron beam, extreme ultraviolet (EUV), X-ray, and ion beam. The amount of the acid generating agent used is preferably 0.001 to 49% by mass of the solid component, more preferably 1 to 40% by mass, still more preferably 3 to 30% by mass, and much more preferably 10 to 25% by mass. By using it within the above range, there is a tendency that a pattern profile with higher sensitivity and low edge roughness can be obtained. In the present embodiment, the acid generation method is not limited as long as an acid is generated within a system. By using excimer laser instead of ultraviolet such as g-ray and i-ray, finer processing is possible, and also by using electron beam, extreme ultraviolet, X-ray or ion beam as a high energy ray, further finer processing is possible.

The acid generating agent is preferably at least one kind selected from the group consisting of compounds represented by the following formulae (7-1) to (7-8):

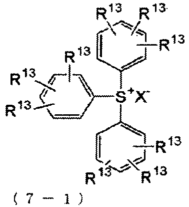

In the formula (7-1), R¹³ may be the same or different, and are each independently a hydrogen atom, a linear, branched or cyclic alkyl group, a linear, branched or cyclic alkoxy group, a hydroxyl group, or a halogen atom; X⁻ is an alkyl group, an aryl group, a sulfonic acid ion having a halogen substituted alkyl group or a halogen substituted aryl group, or a halide ion.

The compound represented by the above formula (7-1) is preferably at least one kind selected from the group consisting of triphenylsulfonium trifluoromethanesulfonate, triphenylsulfonium nonafluoro-n-butanesulfonate, diphenyltolylsulfonium nonafluoro-n-butanesulfonate, triphenylsulfonium perfluoro-n-octanesulfonate, diphenyl-4-methylphenylsulfonium trifluoromethanesulfonate, di-2,4,6-trimethylphenylsulfonium trifluoromethanesulfonate, diphenyl-4-t-butoxyphenylsulfonium trifluoromethanesulfonate, diphenyl-4-t-butoxyphenylsulfonium nonafluoro-n-butanesulfonate, diphenyl-4-hydroxyphenylsulfonium trifluoromethanesulfonate, bis(4-fluorophenyl)-4-hydroxyphenylsulfonium trifluoromethanesulfonate, diphenyl-4-hydroxyphenylsulfonium nonafluoro-n-butanesulfonate, bis(4-hydroxyphenyl)-phenylsulfonium trifluoromethanesulfonate, tri(4-methoxyphenyl)sulfonium trifluoromethanesulfonate, tri(4-fluorophenyl)sulfonium trifluoromethanesulfonate, triphenylsulfonium p-toluenesulfonate, triphenylsulfonium benzenesulfonate, diphenyl-2,4,6-trimethylphenyl-p-toluenesulfonate, diphenyl-2,4,6-trimethylphenylsulfonium-2-trifluoromethylbenzenesulfonate, diphenyl-2,4,6-trimethylphenylsulfonium-4-trifluoromethylbenzenesulfonate, diphenyl-2,4,6-trimethylphenylsulfonium-2,4-difluorobenzenesulfonate, diphenyl-2,4,6-trimethylphenylsulfonium hexafluorobenzenesulfonate, diphenylnaphthylsulfonium trifluoromethanesulfonate, diphenyl-4-hydroxyphenylsulfonium-p-toluenesulfonate, triphenylsulfonium 10-camphorsulfonate, diphenyl-4-hydroxyphenylsulfonium 10-camphorsulfonate, and cyclo(1,3-perfluoropropanedisulfone)imidate.

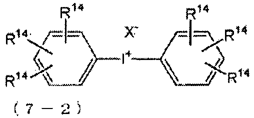

In the formula (7-2), R¹⁴ may be the same or different, and each independently represents a hydrogen atom, a linear, branched or cyclic alkyl group, a linear, branched or cyclic alkoxy group, a hydroxyl group, or a halogen atom. X⁻ is the same as defined above.

The compound represented by the above formula (7-2) is preferably at least one kind selected from the group consisting of bis(4-t-butylphenyl)iodonium trifluoromethanesulfonate, bis(4-t-butylphenyl)iodonium nonafluoro-n-butanesulfonate, bis(4-t-butylphenyl)iodonium perfluoro-n-octanesulfonate, bis(4-t-butylphenyl)iodonium p-toluenesulfonate, bis(4-t-butylphenyl)iodonium benzenesulfonate, bis(4-t-butylphenyl)iodonium-2-trifluoromethylbenzenesulfonate, bis(4-t-butylphenyl)iodonium-4-trifluoromethylbenzenesulfonate, bis(4-t-butylphenyl)iodonium-2,4-difluorobenzenesulfonate, bis(4-t-butylphenyl)iodonium hexafluorobenzenesulfonate, bis(4-t-butylphenyl)iodonium 10-camphorsulfonate, diphenyliodonium trifluoromethanesulfonate, diphenyliodonium nonafluoro-n-butanesulfonate, diphenyliodonium perfluoro-n-octanesulfonate, diphenyliodonium p-toluenesulfonate, diphenyliodonium benzenesulfonate, diphenyliodonium 10-camphorsulfonate, diphenyliodonium-2-trifluoromethylbenzenesulfonate, diphenyliodonium-4-trifluoromethylbenzenesulfonate, diphenyliodonium-2,4-difluorobenzenesulfonate, diphenyliodonium hexafluorobenzenesulfonate, di(4-trifluoromethylphenyl)iodonium trifluoromethanesulfonate, di(4-trifluoromethylphenyl)iodonium nonafluoro-n-butanesulfonate, di(4-trifluoromethylphenyl)iodonium perfluoro-n-octanesulfonate, di(4-trifluoromethylphenyl)iodonium p-toluenesulfonate, di(4-trifluoromethylphenyl)iodonium benzenesulfonate, and di(4-trifluoromethylphenyl)iodonium 10-camphersulfonate.

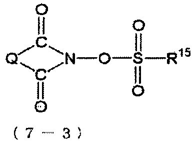

In the formula (7-3), Q is an alkylene group, an arylene group, or an alkoxylene group, and R¹⁵ is an alkyl group, an aryl group, a halogen substituted alkyl group, or a halogen substituted aryl group.

The compound represented by the above formula (7-3) is preferably at least one kind selected from the group consisting of N-(trifluoromethylsulfonyloxy)succinimide, N-(trifluoromethylsulfonyloxy)phthalimide, N-(trifluoromethylsulfonyloxy)diphenylmaleimide, N-(trifluoromethylsulfonyloxy)bicyclo[2.2.1]hept-5-en-2,3-dicarboxyimide, N-(trifluoromethylsulfonyloxy)naphthylimide, N-(10-camphorsulfonyloxy)succinimide, N-(10-camphorsulfonyloxy)phthalimide, N-(10-camphorsulfonyloxy)diphenylmaleimide, N-(10-camphorsulfonyloxy)bicyclo[2.2.1]hept-5-en-2,3-dicarboxyimide, N-(10-camphorsulfonyloxy)naphthylimide, N-(n-octanesulfonyloxy)bicyclo[2.2.1]hept-5-en-2,3-dicarboxyimide, N-(n-octanesulfonyloxy)naphthylimide, N-(p-toluenesulfonyloxy)bicyclo[2.2.1]hept-5-en-2,3-dicarboxyimide, N-(p-toluenesulfonyloxy)naphthylimide, N-(2-trifluoromethylbenzenesulfonyloxy)bicyclo[2.2.1]hept-5-en-2,3-dicarboxyimide, N-(2-trifluoromethylbenzenesulfonyloxy)naphthylimide, N-(4-trifluoromethylbenzenesulfonyloxy)bicyclo[2.2.1]hept-5-en-2,3-dicarboxyimide, N-(4-trifluoromethylbenzenesulfonyloxy)naphthylimide, N-(perfluorobenzenesulfonyloxy)bicyclo[2.2.1]hept-5-en-2,3-dicarboxyimide, N-(perfluorobenzenesulfonyloxy)naphthylimide, N-(1-naphthalenesulfonyloxy)bicyclo[2.2.1]hept-5-en-2,3-dicarboxyimide, N-(1-naphthalenesulfonyloxy)naphthylimide, N-(nonafluoro-n-butanesulfonyloxy)bicyclo[2.2.1]hept-5-en-2,3-dicarboxyimide, N-(nonafluoro-n-butanesulfonyloxy)naphthylimide, N-(perfluoro-n-octanesulfonyloxy)bicyclo[2.2.1]hept-5-en-2,3-dicarboxyimide, and N-(perfluoro-n-octanesulfonyloxy)naphthylimide.

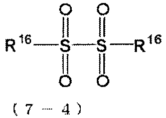

In the formula (7-4), R¹⁶ may be the same or different, and are each independently an optionally substituted linear, branched or cyclic alkyl group, an optionally substituted aryl group, an optionally substituted heteroaryl group, or an optionally substituted aralkyl group.

The compound represented by the above formula (7-4) is preferably at least one kind selected from the group consisting of diphenyldisulfone, di(4-methylphenyl)disulfone, dinaphthyldisulfone, di(4-tert-butylphenyl)disulfone, di(4-hydroxyphenyl)disulfone, di(3-hydroxynaphthyl)disulfone, di(4-fluorophenyl)disulfone, di(2-fluorophenyl)disulfone, and di(4-trifluoromethylphenyl)disulfone.

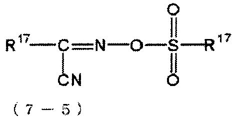

In the formula (7-5), R¹⁷ may be the same or different, and are each independently an optionally substituted linear, branched or cyclic alkyl group, an optionally substituted aryl group, an optionally substituted heteroaryl group, or an optionally substituted aralkyl group.

The compound represented by the above formula (7-5) is preferably at least one kind selected from the group consisting of α-(methylsulfonyloxyimino)-phenylacetonitrile, α-(methylsulfonyloxyimino)-4-methoxyphenylacetonitrile, α-(trifluoromethylsulfonyloxyimino)-phenylacetonitrile, α-(trifluoromethylsulfonyloxyimino)-4-methoxyphenylacetonitrile, α-(ethylsulfonyloxyimino)-4-methoxyphenylacetonitrile, α-(propylsulfonyloxyimino)-4-methylphenylacetonitrile, and α-(methylsulfonyloxyimino)-4-bromophenylacetonitrile.

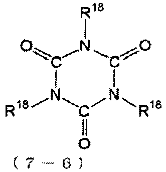

In the formula (7-6), R¹⁸ may be the same or different, and are each independently a halogenated alkyl group having one or more chlorine atoms and one or more bromine atoms. The number of carbon atoms of the halogenated alkyl group is preferably 1 to 5.

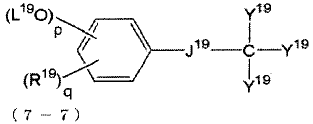

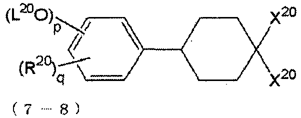

In the formulae (7-7) and (7-8), R¹⁹ and R²⁰ are each independently an alkyl group of 1 to 3 carbon atoms such as a methyl group, an ethyl group, an n-propyl group, and an isopropyl group, a cycloalkyl group such as a cyclopentyl group and a cyclohexyl group, an alkoxyl group of 1 to 3 carbon atoms such as a methoxy group, an ethoxy group, and a propoxy group, or an aryl group such as a phenyl group, a toluoyl group, and a naphthyl group, and preferably an aryl group of 6 to 10 carbon atoms. L¹⁹ and L²⁰ are each independently an organic group having a 1,2-naphthoquinonediazide group. Specifically, preferable examples of the organic group having a 1,2-naphthoquinonediazide group include a 1,2-quinonediazidesulfonyl group such as a 1,2-naphthoquinonediazide-4-sulfonyl group, a 1,2-naphthoquinonediazide-5-sulfonyl group, and a 1,2-naphthoquinonediazide-6-sulfonyl group. Particularly, a 1,2-naphthoquinonediazide-4-sulfonyl group and a 1,2-naphthoquinonediazide-5-sulfonyl group are preferable. p is an integer of 1 to 3; q is an integer of 0 to 4; and 1≤p+q≤5. J¹⁹ is a single bond, a polymethylene group of 1 to 4 carbon atoms, a cycloalkylene group, a phenylene group, a group represented by the following formula (7-7-1), a carbonyl group, an ester group, an amide group, or an ether group. Y¹⁹ is a hydrogen atom, an alkyl group, or an aryl group, and X²⁰ are each independently a group represented by the following formula (7-8-1):

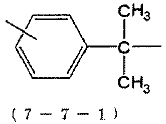

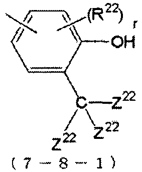

In the formula (7-8-1), Z²² are each independently an alkyl group, a cycloalkyl group, or an aryl group; R²² is an alkyl group, a cycloalkyl group, or an alkoxyl group; and r is an integer of 0 to 3.

Examples of the other acid generating agent include bissulfonyldiazomethanes such as bis(p-toluenesulfonyl)diazomethane, bis(2,4-dimethylphenylsulfonyl)diazomethane, bis(tert-butylsulfonyl)diazomethane, bis(n-butylsulfonyl)diazomethane, bis(isobutylsulfonyl)diazomethane, bis(isopropylsulfonyl)diazomethane, bis(n-propylsulfonyl)diazomethane, bis(cyclohexylsulfonyl)diazomethane, bis(isopropylsulfonyl)diazomethane, 1,3-bis(cyclohexylsulfonylazomethylsulfonyl)propane, 1,4-bis(phenylsulfonylazomethylsulfonyl)butane, 1,6-bis(phenylsulfonylazomethylsulfonyl)hexane, and 1,10-bis(cyclohexylsulfonylazomethylsulfonyl)decane, and halogen-containing triazine derivatives such as 2-(4-methoxyphenyl)-4,6-(bistrichloromethyl)-1,3,5-triazine, 2-(4-methoxynaphthyl)-4,6-(bistrichloromethyl)-1,3,5-triazine, tris(2,3-dibromopropyl)-1,3,5-triazine, and tris(2,3-dibromopropyl)isocyanurate.

Among the above acid generating agents, an acid generating agent having an aromatic ring is preferable, and an acid generating agent represented by the formula (7-1) or (7-2) is more preferable. An acid generating agent having a sulfonate ion wherein X⁻ of the formula (7-1) or (7-2) has an aryl group or a halogen-substituted aryl group is still more preferable; an acid generating agent having a sulfonate ion having an aryl group is particularly preferable; and diphenyltrimethylphenylsulfonium p-toluenesulfonate, triphenylsulfonium p-toluenesulfonate, triphenylsulfonium trifluoromethanesulfonate, and triphenylsulfonium nonafluoromethanesulfonate are particularly preferable. By using the acid generating agent, LER can be reduced.

The above acid generating agent can be used alone or in combination of two or more kinds.

### (2) Acid Crosslinking Agent

The radiation-sensitive composition of the present embodiment preferably contains one or more acid crosslinking agents. The acid crosslinking agent is a compound capable of intramolecular or intermolecular crosslinking the compound represented by the formula (1) in the presence of the acid generated from the acid generating agent. Examples of such an acid crosslinking agent can include, but not limited to, a compound having one or more groups (hereinafter, referred to as "crosslinkable group") capable of crosslinking the compound represented by the formula (1).

Specific examples of such a crosslinkable group include, but not limited to, (i) a hydroxyalkyl group such as a hydroxy (C1-C6 alkyl group), a C1-C6 alkoxy (C1-C6 alkyl group), and an acetoxy (C1-C6 alkyl group), or a group derived therefrom; (ii) a carbonyl group such as a formyl group and a carboxy (C1-C6 alkyl group), or a group derived therefrom; (iii) a nitrogenous group-containing group such as a dimethylaminomethyl group, a diethylaminomethyl group, a dimethylolaminomethyl group, a diethylolaminomethyl group, and a morpholinomethyl group; (iv) a glycidyl group-containing group such as a glycidyl ether group, a glycidyl ester group, and a glycidylamino group; (v) a group derived from an aromatic group such as a C1-C6 allyloxy (C1-C6 alkyl group) and a C1-C6 aralkyloxy (C1-C6 alkyl group) such as a benzyloxymethyl group and a benzoyloxymethyl group; and (vi) a polymerizable multiple bond-containing group such as a vinyl group and a isopropenyl group. As the crosslinkable group of the acid crosslinking agent of the present embodiment, a hydroxyalkyl group and an alkoxyalkyl group or the like are preferable, and an alkoxymethyl group is particularly preferable.

Examples of the acid crosslinking agent having the above crosslinkable group include, but not limited to, (i) a methylol group-containing compound such as a methylol group-containing melamine compound, a methylol group-containing benzoguanamine compound, a methylol group-containing urea compound, a methylol group-containing glycoluryl compound, and a methylol group-containing phenolic compound; (ii) an alkoxyalkyl group-containing compound such as an alkoxyalkyl group-containing melamine compound, an alkoxyalkyl group-containing benzoguanamine compound, an alkoxyalkyl group-containing urea compound, an alkoxyalkyl group-containing glycoluryl compound, and an alkoxyalkyl group-containing phenolic compound; (iii) a carboxymethyl group-containing compound such as a carboxymethyl group-containing melamine compound, a carboxymethyl group-containing benzoguanamine compound, a carboxymethyl group-containing urea compound, a carboxymethyl group-containing glycoluryl compound, and a carboxymethyl group-containing phenolic compound; (iv) an epoxy compound such as a bisphenol A based epoxy compound, a bisphenol F based epoxy compound, a bisphenol S based epoxy compound, a novolac resin based epoxy compound, a resol resin based epoxy compound, and a poly(hydroxystyrene) based epoxy compound.

As the acid crosslinking agent, a compound having a phenolic hydroxyl group, and a compound and resin where the above crosslinkable group is introduced into an acid functional group in an alkali soluble resin to impart crosslinkability can be further used. The introduction rate of the crosslinkable group in that case is adjusted, usually, to be normally 5 to 100 mol %, preferably 10 to 60 mol %, and more preferably 15 to 40 mol % based on the total acid functional groups in the compound having a phenolic hydroxyl group, and the alkali soluble resin. The above range is preferable because there is a tendency that the crosslinking reaction sufficiently occurs, and a decrease in the film remaining rate, and swelling phenomena and meandering or the like of a pattern can be avoided.

In the radiation-sensitive composition of the present embodiment, as the acid crosslinking agent, an alkoxyalkylated urea compound or resin thereof, or an alkoxyalkylated glycoluryl compound or resin thereof is preferable. More preferable examples of the acid crosslinking agent include compounds represented by the following formulae (8-1) to (8-3) and an alkoxymethylated melamine compound (acid crosslinking agent).

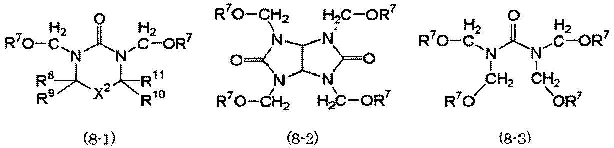

In the above formulae (8-1) to (8-3), R⁷ each independently represents a hydrogen atom, an alkyl group, or an acyl group; R⁸ to R¹¹ each independently represents a hydrogen atom, a hydroxyl group, an alkyl group, or an alkoxyl group; and X² represents a single bond, a methylene group, or an oxygen atom.

The alkyl group represented by the above R⁷ is preferably 1 to 6 carbon atoms, and more preferably 1 to 3 carbon atoms. Examples thereof include a methyl group, an ethyl group, and a propyl group. The acyl group represented by R⁷ is preferably 2 to 6 carbon atoms, and more preferably 2 to 4 carbon atoms. Examples thereof include an acetyl group and a propionyl group. The alkyl group represented by R⁸ to R¹¹ is preferably 1 to 6 carbon atoms, and more preferably 1 to 3 carbon atoms. Examples thereof include a methyl group, an ethyl group, and a propyl group. The alkoxy group represented by R⁸ to R¹¹ is preferably 1 to 6 carbon atoms, and more preferably 1 to 3 carbon atoms. Examples thereof include a methoxy group, an ethoxy group, and a propoxy group. X² is preferably a single bond or a methylene group. R⁷ to R¹¹ and X² may be substituted with an alkyl group such as a methyl group and an ethyl group, an alkoxy group such as a methoxy group and an ethoxy group, a hydroxyl group and a halogen atom or the like. A plurality of R⁷ and R⁸ to R¹¹ may be each the same or different.

Specific examples of the compound represented by the formula (8-1) include compounds shown below:

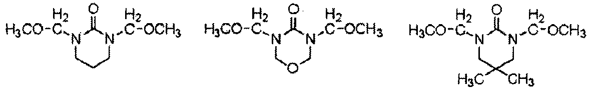

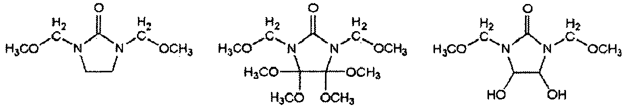

Specific examples of the compound represented by the formula (8-2) include, but not limited to, N,N,N,N-tetra(methoxymethyl)glycoluryl, N,N,N,N-tetra(ethoxymethyl)glycoluryl, N,N,N,N-tetra(n-propoxymethyl)glycoluryl, N,N,N,N-tetra(isopropoxymethyl)glycoluryl, N,N,N,N-tetra(n-butoxymethyl)glycoluryl, and N,N,N,N-tetra(t-butoxymethyl)glycoluryl. Among them, particularly, N,N,N,N-tetra(methoxymethyl)glycoluryl is preferable.

Specific examples of the compound represented by the formula (8-3) include compounds shown below:

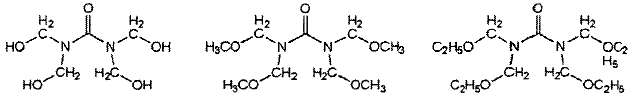

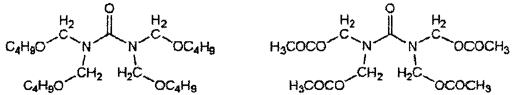

Specific examples of the alkoxymethylated melamine compound include, but not limited to, N,N,N,N,N,N-hexa(methoxymethyl)melamine, N,N,N,N,N,N-hexa(ethoxymethyl)melamine, N,N,N,N,N,N-hexa(n-propoxymethyl)melamine, N,N,N,N,N,N-hexa(isopropoxymethyl)melamine, N,N,N,N,N,N-hexa(n-butoxymethyl)melamine, and N,N,N,N,N,N-hexa(t-butoxymethyl)melamine. Among them, particularly, N,N,N,N,N,N-hexa(methoxymethyl)melamine is preferable.

The above acid crosslinking agent can be obtained by, for example, conducting a condensation reaction of a urea compound or a glycoluryl compound with formalin to introduce an methylol group, etherifying the product with lower alcohols such as methyl alcohol, ethyl alcohol, propyl alcohol, and butyl alcohol, and then cooling the reaction solution to collect a precipitated compound or resin thereof. The above acid crosslinking agent can be obtained as a commercially available product such as CYMEL (trade name, manufactured by MT AquaPolymer) and NIKALAC (manufactured by Sanwa Chemical).

Other particularly preferable examples of the acid crosslinking agent include a phenol derivative having 1 to 6 benzene rings within a molecule and two or more hydroxyalkyl groups and/or alkoxyalkyl groups within the entire molecule, the hydroxyalkyl groups and/or alkoxyalkyl groups being bonded to any of the above benzene rings. Preferable examples thereof include a phenol derivative having a molecular weight of 1500 or less, 1 to 6 benzene rings and a total of two or more hydroxyalkyl groups and/or alkoxyalkyl groups within a molecule, the hydroxyalkyl groups and/or alkoxyalkyl groups being bonded to any one of the above benzene rings, or a plurality of benzene rings.

The hydroxyalkyl group bonded to a benzene ring is the one of 1 to 6 carbon atoms such as a hydroxymethyl group, a 2-hydroxyethyl group, a 2-hydroxy-1-propyl group is preferable. As the alkoxyalkyl group bonded to a benzene ring, the one of 2 to 6 carbon atoms is preferable. Specifically, a methoxymethyl group, an ethoxymethyl group, an n-propoxymethyl group, an isopropoxymethyl group, an n-butoxymethyl group, an isobutoxymethyl group, a sec-butoxymethyl group, a t-butoxymethyl group, a 2-methoxyethyl group, or a 2-methoxy-1-propyl group is preferable.

Among these phenol derivatives, particularly preferable ones are shown below:

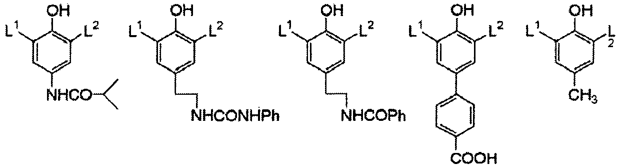

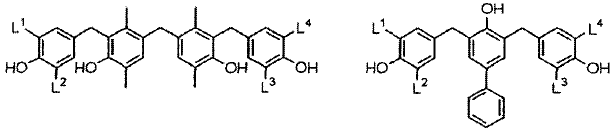

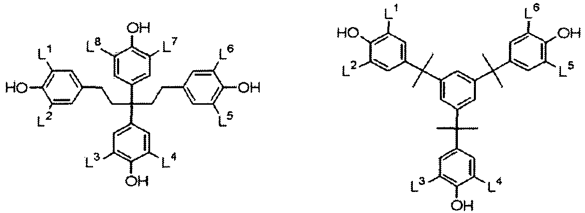

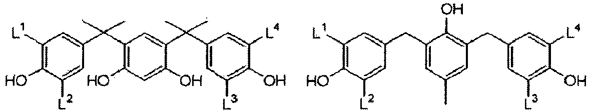

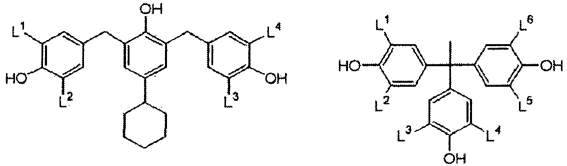

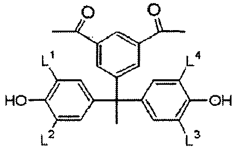

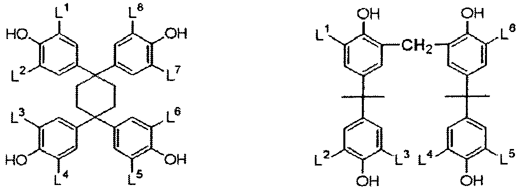

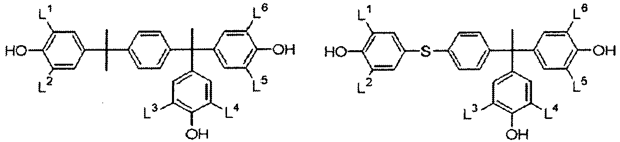

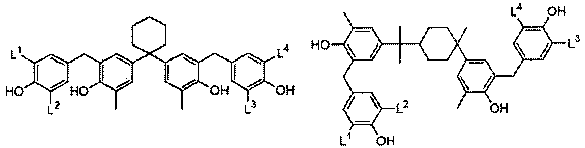

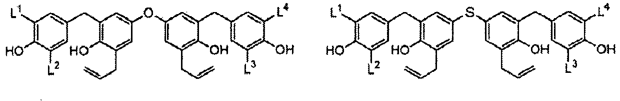

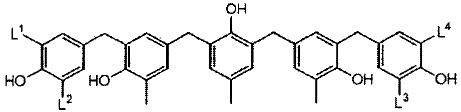

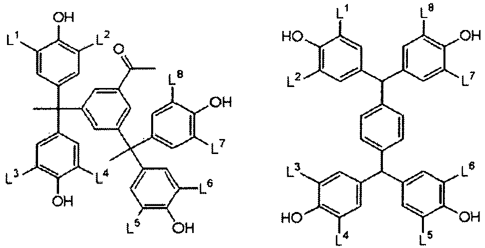

In the above formulae, L¹ to L⁸ may be the same or different, and each independently represents a hydroxymethyl group, a methoxymethyl group, or an ethoxymethyl group. A phenol derivative having a hydroxymethyl group can be obtained by reacting the corresponding phenolic compound having no hydroxymethyl group (a compound where L¹ to L⁸ in the above formulae are a hydrogen atom) with formaldehyde in the presence of a basic catalyst. In this case, in order to prevent resinification and gelation, the reaction temperature is preferably 60°C or less. Specifically, it can be synthesized by methods described in Japanese Patent Application Laid-Open Nos. 6-282067 and 7-64285 or the like.

A phenol derivative having an alkoxymethyl group can be obtained by reacting the corresponding phenol derivative having a hydroxymethyl group with an alcohol in the presence of an acid catalyst. In this case, in order to prevent resinification and gelation, the reaction temperature is preferably 100°C or less. Specifically, it can be synthesized by methods described in EP632003A1 or the like.

While the phenol derivative having a hydroxymethyl group and/or an alkoxymethyl group thus synthesized is preferable in terms of stability upon storage, the phenol derivative having an alkoxymethyl group is particularly preferable in terms of stability upon storage. The acid crosslinking agent may be used alone, or may be used in combination of two or more kinds.

Other particularly preferable examples of the acid crosslinking agent include a compound having at least one α-hydroxyisopropyl group. The compound is not particularly limited in the structure, as long as it has an α-hydroxyisopropyl group. A hydrogen atom of a hydroxyl group in the above α-hydroxyisopropyl group may be substituted with one or more acid dissociation groups (R-COO- group, R-SO₂- group or the like, wherein the R represents a substituent group selected from the group consisting of a linear hydrocarbon group of 1 to 12 carbon atoms, a cyclic hydrocarbon group of 3 to 12 carbon atoms, an alkoxy group of 1 to 12 carbon atoms, a 1-branched alkyl group of 3 to 12 carbon atoms, and an aromatic hydrocarbon group of 6 to 12 carbon atoms). Examples of a compound having the above α-hydroxyisopropyl group include one kind or two kinds or more of a substituted or non-substituted aromatic based compound, a diphenyl compound, a naphthalene compound, a furan compound or the like containing at least one α-hydroxyisopropyl group. Specific examples thereof include a compound represented by the following general formula (9-1) (hereinafter, referred to as "benzene based compound (1)"), a compound represented by the following general formula (9-2) (hereinafter, referred to as "diphenyl based compound (2)"), a compound represented by the following general formula (9-3) (hereinafter, referred to as "naphthalene based compound (3)"), and a compound represented by the following general formula (9-4) (hereinafter, referred to as "furan based compound (4)").

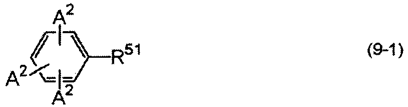

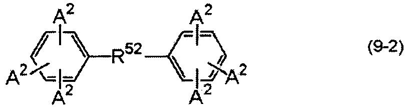

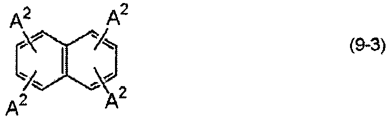

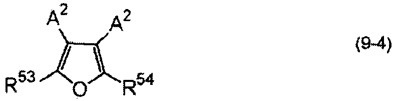

In the above general formulae (9-1) to (9-4), each A² independently represents an α-hydroxyisopropyl group or a hydrogen atom, and at least one A² is an α-hydroxyisopropyl group. In the general formula (9-1), R⁵¹ represents a hydrogen atom, a hydroxyl group, a linear or branched alkylcarbonyl group of 2 to 6 carbon atoms, or a linear or branched alkoxycarbonyl group of 2 to 6 carbon atoms. Furthermore, in the general formula (9-2), R⁵² represents a single bond, a linear or branched alkylene group of 1 to 5 carbon atoms, -O-, -CO-, or -COO-. Also, in the general formula (9-4), R⁵³ and R⁵⁴ represent a hydrogen atom or a linear or branched alkyl group of 1 to 6 carbon atoms independently from each other.

Specific examples of the above benzene based compound (1) include, but not limited to, α-hydroxyisopropylbenzenes such as α-hydroxyisopropylbenzene, 1,3-bis(α-hydroxyisopropyl)benzene, 1,4-bis(α-hydroxyisopropyl)benzene, 1,2,4-tris(α-hydroxyisopropyl)benzene, and 1,3,5-tris(α-hydroxyisopropyl)benzene; α-hydroxyisopropylphenols such as 3-α-hydroxyisopropylphenol, 4-α-hydroxyisopropylphenol, 3,5-bis(α-hydroxyisopropyl)phenol, and 2,4,6-tris(α-hydroxyisopropyl)phenol; α-hydroxyisopropylphenyl alkyl ketones such as 3-α-hydroxyisopropylphenyl methyl ketone, 4-α-hydroxyisopropylphenyl methyl ketone, 4-α-hydroxyisopropylphenyl ethyl ketone, 4-α-hydroxyisopropylphenyl-n-propyl ketone, 4-α-hydroxyisopropylphenyl isopropyl ketone, 4-α-hydroxyisopropylphenyl-n-butyl ketone, 4-α-hydroxyisopropylphenyl-t-butyl ketone, 4-α-hydroxyisopropylphenyl-n-pentyl ketone, 3,5-bis(α-hydroxyisopropyl)phenyl-methyl ketone, 3,5-bis(α-hydroxyisopropyl)phenyl ethyl ketone, and 2,4,6-tris(α-hydroxyisopropyl)phenyl methyl ketone; alkyl 4-α-hydroxyisopropylbenzoates such as methyl 3-α-hydroxyisopropylbenzoate, methyl 4-α-hydroxyisopropylbenzoate, ethyl 4-α-hydroxyisopropylbenzoate, n-propyl 4-α-hydroxyisopropylbenzoate, isopropyl 4-α-hydroxyisopropylbenzoate, n-butyl 4-α-hydroxyisopropylbenzoate, t-butyl 4-α-hydroxyisopropylbenzoate, n-pentyl 4-α-hydroxyisopropylbenzoate, methyl 3,5-bis(α-hydroxyisopropyl)benzoate, ethyl 3,5-bis(α-hydroxyisopropyl)benzoate, and methyl 2,4,6-tris(α-hydroxyisopropyl)benzoate.

Specific examples of the above diphenyl based compound (2) include, but not limited to, α-hydroxyisopropylbiphenyls such as 3-α-hydroxyisopropylbiphenyl, 4-α-hydroxyisopropylbiphenyl, 3,5-bis(α-hydroxyisopropyl)biphenyl, 3,3'-bis(α-hydroxyisopropyl)biphenyl, 3,4'-bis(α-hydroxyisopropyl)biphenyl, 4,4'-bis(α-hydroxyisopropyl)biphenyl, 2,4,6-tris(α-hydroxyisopropyl)biphenyl, 3,3',5-tris(α-hydroxyisopropyl)biphenyl, 3,4',5-tris(α-hydroxyisopropyl)biphenyl, 2,3',4,6,-tetrakis(α-hydroxyisopropyl)biphenyl, 2,4,4',6,-tetrakis(α-hydroxyisopropyl)biphenyl, 3,3',5,5'-tetrakis(α-hydroxyisopropyl)biphenyl, 2,3',4,5',6-pentakis(α-hydroxyisopropyl)biphenyl, and 2,2',4,4',6,6'-hexakis(α-hydroxyisopropyl)biphenyl; α-hydroxyisopropyldiphenylalkanes such as 3-α-hydroxyisopropyldiphenylmethane, 4-α-hydroxyisopropyldiphenylmethane, 1-(4-α-hydroxyisopropylphenyl)-2-phenylethane, 1-(4-α-hydroxyisopropylphenyl)-2-phenylpropane, 2-(4-α-hydroxyisopropylphenyl)-2-phenylpropane, 1-(4-α-hydroxyisopropylphenyl)-3-phenylpropane, 1-(4-α-hydroxyisopropylphenyl)-4-phenylbutane, 1-(4-α-hydroxyisopropylphenyl)-5-phenylpentane, 3,5-bis(α-hydroxyisopropyldiphenylmethane, 3,3'-bis(α-hydroxyisopropyl)diphenylmethane, 3,4'-bis(α-hydroxyisopropyl)diphenylmethane, 4,4'-bis(α-hydroxyisopropyl)diphenylmethane, 1,2-bis(4-α-hydroxyisopropylphenyl)ethane, 1,2-bis(4-α-hydroxypropylphenyl)propane, 2,2-bis(4-α-hydroxypropylphenyl)propane, 1,3-bis(4-α-hydroxypropylphenyl)propane, 2,4,6-tris(α-hydroxyisopropyl)diphenylmethane, 3,3',5-tris(α-hydroxyisopropyl)diphenylmethane, 3,4',5-tris(α-hydroxyisopropyl)diphenylmethane, 2,3',4,6-tetrakis(α-hydroxyisopropyl)diphenylmethane, 2,4,4',6-tetrakis(α-hydroxyisopropyl)diphenylmethane, 3,3',5,5'-tetrakis(α-hydroxyisopropyl)diphenylmethane, 2,3',4,5',6-pentakis(α-hydroxyisopropyl)diphenylmethane, and 2,2',4,4',6,6'-hexakis(α-hydroxyisopropyl)diphenylmethane; α-hydroxyisopropyldiphenyl ethers such as 3-α-hydroxyisopropyldiphenyl ether, 4-α-hydroxyisopropyldiphenyl ether, 3,5-bis(α-hydroxyisopropyl)diphenyl ether, 3,3'-bis(α-hydroxyisopropyl)diphenyl ether, 3,4'-bis(α-hydroxyisopropyl)diphenyl ether, 4,4'-bis(α-hydroxyisopropyl)diphenyl ether, 2,4,6-tris(α-hydroxyisopropyl)diphenyl ether, 3,3',5-tris(α-hydroxyisopropyl)diphenyl ether, 3,4',5-tris(α-hydroxyisopropyl)diphenyl ether, 2,3',4,6-tetrakis(α-hydroxyisopropyl)diphenyl ether, 2,4,4',6-tetrakis(α-hydroxyisopropyl)diphenyl ether, 3,3',5,5'-tetrakis(α-hydroxyisopropyl)diphenyl ether, 2,3',4,5',6-pentakis(α-hydroxyisopropyl)diphenyl ether, and 2,2',4,4',6,6'-hexakis(α-hydroxyisopropyl)diphenyl ether; α-hydroxyisopropyldiphenyl ketones such as 3-α-hydroxyisopropyldiphenyl ketone, 4-α-hydroxyisopropyldiphenyl ketone, 3,5-bis(α-hydroxyisopropyl)diphenyl ketone, 3,3'-bis(α-hydroxyisopropyl)diphenyl ketone, 3,4'-bis(α-hydroxyisopropyl)diphenyl ketone, 4,4'-bis(α-hydroxyisopropyl)diphenyl ketone, 2,4,6-tris(α-hydroxyisopropyl)diphenyl ketone, 3,3',5-tris(α-hydroxyisopropyl)diphenyl ketone, 3,4',5-tris(α-hydroxyisopropyl)diphenyl ketone, 2,3',4,6-tetrakis(α-hydroxyisopropyl)diphenyl ketone, 2,4,4',6-tetrakis(α-hydroxyisopropyl)diphenyl ketone, 3,3',5,5'-tetrakis(α-hydroxyisopropyl)diphenyl ketone, 2,3',4,5',6-pentakis(α-hydroxyisopropyl)diphenyl ketone, and 2,2',4,4',6,6'-hexakis(α-hydroxyisopropyl)diphenyl ketone; phenyl α-hydroxyisopropylbenzoates such as phenyl 3-α-hydroxyisopropylbenzoate, phenyl 4-α-hydroxyisopropylbenzoate, 3-α-hydroxyisopropylphenyl benzoate, 4-α-hydroxyisopropylphenyl benzoate, phenyl 3,5-bis(α-hydroxyisopropyl)benzoate, 3-α-hydroxyisopropylphenyl 3-α-hydroxyisopropylbenzoate, 4-α-hydroxyisopropylphenyl 3-α-hydroxyisopropylbenzoate, 3-α-hydroxyisopropylphenyl 4-α-hydroxyisopropylbenzoate, 4-α-hydroxyisopropylphenyl 4-α-hydroxyisopropylbenzoate, 3,5-bis(α-hydroxyisopropyl)phenyl benzoate, phenyl 2,4,6-tris(α-hydroxyisopropyl)benzoate, 3-α-hydroxyisopropylphenyl 3,5-bis(α-hydroxyisopropyl)benzoate, 4-α-hydroxyisopropylphenyl 3,5-bis(α-hydroxyisopropyl)benzoate, 3,5-bis(α-hydroxyisopropyl)phenyl 3-α-hydroxyisopropylbenzoate, 3,5-bis(α-hydroxyisopropyl)phenyl 4-α-hydroxyisopropylbenzoate, 2,4,6-tris(α-hydroxyisopropyl)phenyl benzoate, 3-α-hydroxyisopropylphenyl 2,4,6-tris(α-hydroxyisopropyl)benzoate, 4-α-hydroxyisopropylphenyl 2,4,6-tris(α-hydroxyisopropyl)benzoate, 3,5-bis(α-hydroxyisopropyl)phenyl 3,5-bis(α-hydroxyisopropyl)benzoate, 2,4,6-tris(α-hydroxyisopropyl)phenyl 3-α-hydroxyisopropylbenzoate, 2,4,6-tris(α-hydroxyisopropyl)phenyl 4-α-hydroxyisopropylbenzoate, 3,5-bis(α-hydroxyisopropyl)phenyl 2,4,6-tris(α-hydroxyisopropyl)benzoate, 2,4,6-tris(α-hydroxyisopropyl)phenyl 3,5-bis(α-hydroxyisopropyl)benzoate, and 2,4,6-tris(α-hydroxyisopropyl)phenyl 2,4,6-tris(α-hydroxyisopropyl)benzoate.

Furthermore, specific examples of the above naphthalene based compound (3) include, but not limited to, 1-(α-hydroxyisopropyl)naphthalene, 2-(α-hydroxyisopropyl)naphthalene, 1,3-bis(α-hydroxyisopropyl)naphthalene, 1,4-bis(α-hydroxyisopropyl)naphthalene, 1,5-bis(α-hydroxyisopropyl)naphthalene, 1,6-bis(α-hydroxyisopropyl)naphthalene, 1,7-bis(α-hydroxyisopropyl)naphthalene, 2,6-bis(α-hydroxyisopropyl)naphthalene, 2,7-bis(α-hydroxyisopropyl)naphthalene, 1,3,5-tris(α-hydroxyisopropyl)naphthalene, 1,3,6-tris(α-hydroxyisopropyl)naphthalene, 1,3,7-tris(α-hydroxyisopropyl)naphthalene, 1,4,6-tris(α-hydroxyisopropyl)naphthalene, 1,4,7-tris(α-hydroxyisopropyl)naphthalene, and 1,3,5,7-tetrakis(α-hydroxyisopropyl)naphthalene.

Specific examples of the above furan based compound (4) include, but not limited to, 3-(α-hydroxyisopropyl)furan, 2-methyl-3-(α-hydroxyisopropyl)furan, 2-methyl-4-(α-hydroxyisopropyl)furan, 2-ethyl-4-(α-hydroxyisopropyl)furan, 2-n-propyl-4-(α-hydroxyisopropyl)furan, 2-isopropyl-4-(α-hydroxyisopropyl)furan, 2-n-butyl-4-(α-hydroxyisopropyl)furan, 2-t-butyl-4-(α-hydroxyisopropyl)furan, 2-n-pentyl-4-(α-hydroxyisopropyl)furan, 2,5-dimethyl-3-(α-hydroxyisopropyl)furan, 2,5-diethyl-3-(α-hydroxyisopropyl)furan, 3,4-bis(α-hydroxyisopropyl)furan, 2,5-dimethyl-3,4-bis(α-hydroxyisopropyl)furan, and 2,5-diethyl-3,4-bis(α-hydroxyisopropyl)furan.

As the above acid crosslinking agent, a compound having two or more free α-hydroxyisopropyl groups is preferable; the above benzene based compound (1) having two or more α-hydroxyisopropyl groups, the above diphenyl based compound (2) having two or more α-hydroxyisopropyl groups, and the above naphthalene based compound (3) having two or more α-hydroxyisopropyl groups are more preferable; and α-hydroxyisopropylbiphenyls having two or more α-hydroxyisopropyl groups and the above naphthalene based compound (3) having two or more α-hydroxyisopropyl groups are particularly preferable.

The above acid crosslinking agent can normally be obtained by a method for reacting an acetyl group-containing compound such as 1,3-diacetylbenzene with Grignard reagent such as CH₃MgBr to methylate and then hydrolyzing, or a method for oxidizing an isopropyl group-containing compound such as 1,3-diisopropylbenzene with oxygen or the like to produce a peroxide and then reducing.

The amount of the acid crosslinking agent used in the present embodiment is preferably 0.5 to 49% by mass of the solid component, more preferably 0.5 to 40% by mass, still more preferably 1 to 30% by mass, and particularly preferably 2 to 20% by mass. The content ratio of the above acid crosslinking agent is preferably 0.5% by mass or more because there is a tendency that the inhibiting effect of the solubility of a resist film in an alkaline developing solution can be improved, and a decrease in the film remaining rate, and occurrence of swelling and meandering of a pattern can be inhibited. On the other hand, 50% by mass or less is preferable because there is a tendency that a decrease in heat resistance as a resist can be further inhibited.

The above content ratio of at least one kind of compound of the above acid crosslinking agent is also not particularly limited, and can be within various ranges according to the kind of substrates or the like used upon forming a resist pattern.

In all acid crosslinking agent components, the content of the above alkoxymethylated melamine compound and/or the compounds represented by (9-1) to (9-3) is preferably 50 to 99% by mass, more preferably 60 to 99% by mass, still more preferably 70 to 98% by mass, and much more preferably 80 to 97% by mass. The alkoxymethylated melamine compound and/or the compounds represented by (9-1) to (9-3) of 50% by mass or more of all acid crosslinking agent components is preferable because there is a tendency that the resolution can be improved. The compounds of 99% by mass or less are preferable because there is a tendency that the pattern cross section is likely to have a rectangular shape.

### (3) Acid Diffusion Controlling Agent

In the present embodiment, an acid diffusion controlling agent having a function of controlling diffusion of an acid generated from an acid generating agent by radiation irradiation in a resist film to inhibit any unpreferable chemical reaction in an unexposed region or the like may be blended in the radiation-sensitive composition. By using such an acid diffusion controlling agent, there is a tendency that the storage stability of a radiation-sensitive composition is improved. Also, there is a tendency that, along with the improvement of the resolution, the line width change of a resist pattern due to variation in the post exposure delay time before radiation irradiation and the post exposure delay time after radiation irradiation can be inhibited, and the composition has more excellent process stability. Examples of such an acid diffusion controlling agent include a radiation degradable basic compound such as a nitrogen atom-containing basic compound, a basic sulfonium compound, and a basic iodonium compound. The acid diffusion controlling agent can be used alone or in combination of two or more kinds.

Examples of the above acid diffusion controlling agent include, but not limited to, a nitrogen-containing organic compound, and a basic compound degradable by exposure. Examples of the above nitrogen-containing organic compound include, but not limited to, a compound represented by the following general formula (10) (hereinafter, referred to as a "nitrogen-containing compound (I)"), a diamino compound having two nitrogen atoms within the same molecule (hereinafter, referred to as a "nitrogen-containing compound (II)"), a polyamino compound or polymer having three or more nitrogen atoms (hereinafter, referred to as a "nitrogen-containing compound (III)"), an amide group-containing compound, a urea compound, and a nitrogen-containing heterocyclic compound. The acid diffusion controlling agent (E) may be used alone as one kind or may be used in combination of two or more kinds.

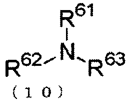

In the above general formula (10), R⁶¹, R⁶², and R⁶³ represent a hydrogen atom, a linear, branched or cyclic alkyl group, an aryl group, or an aralkyl group independently from each other. The above alkyl group, aryl group, or aralkyl group may be non-substituted or may be substituted with a hydroxyl group or the like. Herein, examples of the above linear, branched or cyclic alkyl group include, but not limited to, the one of 1 to 15 carbon atoms, and preferably 1 to 10 carbon atoms. Specific examples thereof include a methyl group, an ethyl group, an n-propyl group, an isopropyl group, an n-butyl group, an isobutyl group, a sec-butyl group, a t-butyl group, an n-pentyl group, a neopentyl group, an n-hexyl group, a texyl group, an n-heptyl group, an n-octyl group, an n-ethylhexyl group, an n-nonyl group, and an n-decyl group. Examples of the above aryl group include, but not limited to, the one of 6 to 12 carbon atoms. Specific examples thereof include a phenyl group, a tolyl group, a xylyl group, a cumenyl group, and a 1-naphthyl group. Furthermore, examples of the above aralkyl group include the one of 7 to 19 carbon atoms, and preferably 7 to 13 carbon atoms. Specific examples thereof include a benzyl group, an α-methylbenzyl group, a phenethyl group, and a naphthylmethyl group.

Specific examples of the above nitrogen-containing compound (I) include, but not limited to, mono(cyclo)alkylamines such as n-hexylamine, n-heptylamine, n-octylamine, n-nonylamine, n-decylamine, n-dodecylamine, and cyclohexylamine; di(cyclo)alkylamines such as di-n-butylamine, di-n-pentylamine, di-n-hexylamine, di-n-heptylamine, di-n-octylamine, di-n-nonylamine, di-n-decylamine, methyl-n-dodecylamine, di-n-dodecylmethyl, cyclohexylmethylamine, and dicyclohexylamine; tri(cyclo)alkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, dimethyl-n-dodecylamine, di-n-dodecylmethylamine, dicyclohexylmethylamine, and tricyclohexylamine; alkanolamines such as monoethanolamine, diethanolamine, and triethanolamine; and aromatic amines such as aniline, N-methylaniline, N,N-dimethylaniline, 2-methylaniline, 3-methylaniline, 4-methylaniline, 4-nitroaniline, diphenylamine, triphenylamine, and 1-naphthylamine.

Specific examples of the above nitrogen-containing compound (II) include, but not limited to, ethylenediamine, N,N,N',N'-tetramethylethylenediamine, N,N,N',N'-tetrakis(2-hydroxypropyl)ethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, and 1,3-bis[1-(4-aminophenyl)-1-methylethyl]benzene.

Specific examples of the above nitrogen-containing compound (III) include, but not limited to, polymers of polyethyleneimine, polyarylamine, and N-(2-dimethylaminoethyl)acrylamide.

Specific examples of the above amide group-containing compound include, but not limited to, formamide, N-methylformamide, N,N-dimethylformamide, acetamide, N-methylacetamide, N,N-dimethylacetamide, propioneamide, benzamide, pyrrolidone, and N-methylpyrrolidone.

Specific examples of the above urea compound include, but not limited to, urea, methylurea, 1,1-dimethylurea, 1,3-dimethylurea, 1,1,3,3-tetramethylurea, 1,3-diphenylurea, and tri-n-butylthiourea.

Specific examples of the above nitrogen-containing heterocyclic compound include, but not limited to, imidazoles such as imidazole, benzimidazole, 4-methylimidazole, 4-methyl-2-phenylimidazole, and 2-phenylbenzimidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, amide nicotinate, quinoline, 8-oxyquinoline, and acridine; and pyrazine, pyrazole, pyridazine, quinozaline, purine, pyrrolidine, piperidine, morpholine, 4-methylmorpholine, piperazine, 1,4-dimethylpiperazine, and 1,4-diazabicyclo[2.2.2]octane.

Examples of the above radiation degradable basic compound include, but not limited to, a sulfonium compound represented by the following general formula (11-1) and an iodonium compound represented by the following general formula (11-2).

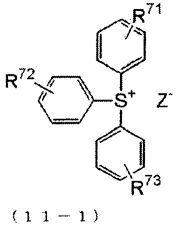

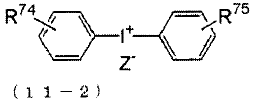

In the above general formulae (11-1) and (11-2), R⁷¹, R⁷², R⁷³, R⁷⁴, and R⁷⁵ represent a hydrogen atom, an alkyl group of 1 to 6 carbon atoms, an alkoxyl group of 1 to 6 carbon atoms, a hydroxyl group, or a halogen atom independently from each other. Z⁻ represents HO⁻, R-COO⁻ (R represents an alkyl group of 1 to 6 carbon atoms, an aryl group of 6 to 11 carbon atoms, or an alkaryl group of 7 to 12 carbon atoms), or an anion represented by the following general formula (11-3).

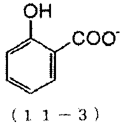

Specific examples of the above radiation degradable basic compound include, but not limited to, triphenylsulfonium hydroxide, triphenylsulfonium acetate, triphenylsulfonium salicylate, diphenyl-4-hydroxyphenylsulfonium hydroxide, diphenyl-4-hydroxyphenylsulfonium acetate, diphenyl-4-hydroxyphenylsulfonium salicylate, bis(4-t-butylphenyl)iodonium hydroxide, bis(4-t-butylphenyl)iodonium acetate, bis(4-t-butylphenyl)iodonium hydroxide, bis(4-t-butylphenyl)iodonium acetate, bis(4-t-butylphenyl)iodonium salicylate, 4-t-butylphenyl-4-hydroxyphenyliodonium hydroxide, 4-t-butylphenyl-4-hydroxyphenyliodonium acetate, and 4-t-butylphenyl-4-hydroxyphenyliodonium salicylate.

The content of the acid diffusion controlling agent is preferably 0.001 to 49% by mass of the solid component, more preferably 0.01 to 10% by mass, still more preferably 0.01 to 5% by mass, and much more preferably 0.01 to 3% by mass. There is a tendancy that in the above range, a decrease in resolution, and deterioration of the pattern shape and the dimension fidelity or the like can be prevented. Moreover, even though the post exposure delay time from electron beam irradiation to heating after radiation irradiation becomes longer, there is a tendency that deterioration of the shape of the pattern upper layer portion can be prevented. When the content is 10% by mass or less, there is a tendency that a decrease in sensitivity, and developability of the unexposed portion or the like can be prevented. By using such an acid diffusion controlling agent, there is a tendency that the storage stability of a radiation-sensitive composition improves, also along with improvement of the resolution, the line width change of a resist pattern due to variation in the post exposure delay time before radiation irradiation and the post exposure delay time after radiation irradiation can be inhibited, and the composition becomes more excellent from the viewpoint of process stability.

### (4) Dissolution Promoting Agent

A dissolution promoting agent is a component having a function of increasing the solubility of a compound represented by the formula (1) in a developing solution to moderately increase the dissolution rate of the resist base material upon developing, when the solubility of the compound is too low. The low molecular weight dissolution promoting agent can be used, within the range of not deteriorating the effect of the present embodiment. Examples of the above dissolution promoting agent can include, but not limited to, a low molecular weight phenolic compound. Examples of the low molecular weight phenolic compound can include, but not limited to, bisphenols and tris(hydroxyphenyl)methane. These dissolution promoting agents can be used alone or in mixture of two or more kinds. The content of the dissolution promoting agent, which is arbitrarily adjusted according to the kind of the compound represented by the formula (1) to be used, is preferably 0 to 49% by mass of the solid component, more preferably 0 to 5% by mass, still more preferably 0 to 1% by mass, and much more preferably 0% by mass.

### (5) Dissolution Controlling Agent

The dissolution controlling agent is a component having a function of controlling the solubility of the compound represented by the formula (1) in a developing solution to moderately decrease the dissolution rate upon developing, when the solubility of the compound is too high. As such a dissolution controlling agent, the one which does not chemically change in steps such as calcination of resist coating, radiation irradiation, and development is preferable.

Examples of the dissolution controlling agent include, but not limited to, aromatic hydrocarbons such as phenanthrene, anthracene, and acenaphthene; ketones such as acetophenone, benzophenone, and phenyl naphtyl ketone; and sulfones such as methyl phenyl sulfone, diphenyl sulfone, and dinaphthyl sulfone. These dissolution controlling agents can be used alone or in two or more kinds.

The content of the dissolution controlling agent is arbitrarily adjusted according to the kind of the compound represented by the formula (1) to be used, is preferably 0 to 49% by mass of the solid component, more preferably 0 to 5% by mass, still more preferably 0 to 1% by mass, and much more preferably 0% by mass.

### (6) Sensitizing Agent

The sensitizing agent is a component having a function of absorbing irradiated radiation energy, transmitting the energy to the acid generating agent, and thereby increasing the acid production amount, and improving the apparent sensitivity of a resist. Examples of such a sensitizing agent can include, but not particularly limited to, benzophenones, biacetyls, pyrenes, phenothiazines, and fluorenes. These sensitizing agents can be used alone or in two or more kinds. The content of the sensitizing agent, which is arbitrarily adjusted according to the kind of the compound represented by the formula (1) to be used, is preferably 0 to 49% by mass of the solid component, more preferably 0 to 5% by mass, still more preferably 0 to 1% by mass, and much more preferably 0% by mass.

### (7) Surfactant

The surfactant is a component having a function of improving coatability and striation of the radiation-sensitive composition of the present embodiment, and developability of a resist or the like. Such a surfactant may be any of anionic, cationic, nonionic or amphoteric. A preferable surfactant is a nonionic surfactant. The nonionic surfactant has a good affinity with a solvent used in production of radiation-sensitive compositions and more effects. Examples of the nonionic surfactant include, but not particularly limited to, a polyoxyethylene higher alkyl ethers, polyoxyethylene higher alkyl phenyl ethers, and higher fatty acid diesters of polyethylene glycol. Examples of commercially available products include, but not limited to, hereinafter by trade name, EFTOP (manufactured by Jemco Inc.), MEGAFAC (manufactured by DIC Corporation), Fluorad (manufactured by Sumitomo 3M Limited), AsahiGuard, Surflon (hereinbefore, manufactured by Asahi Glass Co., Ltd.), Pepole (manufactured by Toho Chemical Industry Co., Ltd.), KP (manufactured by Shin-Etsu Chemical Co., Ltd.), and Polyflow (manufactured by Kyoeisha Chemical Co., Ltd.). The content of the surfactant is arbitrarily adjusted according to the kind of the compound represented by the formula (1) to be used, is preferably 0 to 49% by mass of the solid component, more preferably 0 to 5% by mass, still more preferably 0 to 1% by mass, and much more preferably 0% by mass.

### (8) Organic Carboxylic Acid or Oxo Acid of Phosphor or Derivative Thereof

For the purpose of prevention of sensitivity deterioration or improvement of a resist pattern shape and post exposure delay stability or the like, and as an additional optional component, the resist composition of the present embodiment may contain an organic carboxylic acid or an oxo acid of phosphor or derivative thereof. The composition can be used in combination with the acid diffusion controlling agent, or may be used alone. As the organic carboxylic acid, for example, malonic acid, citric acid, malic acid, succinic acid, benzoic acid, and salicylic acid, or the like are preferable. Examples of the oxo acid of phosphor or derivative thereof include, but not limited to, phosphoric acid or derivative thereof such as ester including phosphoric acid, di-n-butyl ester phosphate, and diphenyl ester phosphate, phosphonic acid or derivative thereof such as ester including phosphonic acid, dimethyl ester phosphonate, di-n-butyl ester phosphonate, phenylphosphonic acid, diphenyl ester phosphonate, and dibenzyl ester phosphonate, and phosphinic acid and derivative thereof such as ester including phosphinic acid and phenylphosphinic acid. Among them, phosphonic acid is preferable.

The organic carboxylic acid or the oxo acid of phosphor or derivative thereof can be used alone or in combination of two or more kinds. The content of the organic carboxylic acid or the oxo acid of phosphor or derivative thereof, which is arbitrarily adjusted according to the kind of the compound represented by the formula (1) to be used, is preferably 0 to 49% by mass of the solid component, more preferably 0 to 5% by mass, still more preferably 0 to 1% by mass, and much more preferably 0% by mass.

### (9) Additional Additive Other Than Above Dissolution Controlling Agent, Sensitizing Agent, Surfactant and Organic Carboxylic Acid or Oxo Acid of Phosphor, or Derivative Thereof

Furthermore, one kind or two kinds or more of additive agents other than the above dissolution controlling agent, sensitizing agent, and surfactant and an organic carboxylic acid or an oxo acid of phosphor, or derivative thereof can be blended in the radiation-sensitive composition of the present embodiment, within the range of not inhibiting the purpose of the present embodiment, if required. Examples of such an additive agent include, but not limited to, a dye, a pigment, and an adhesion aid. For example, the dye or the pigment is blended in the composition, and thereby a latent image of the exposed portion can be visualized and influence of halation upon exposure can be alleviated, which is preferable. The adhesion aid is blended in the composition contains, and thereby adhesiveness to a substrate can be improved, which is preferable. Furthermore, examples of other additive agent include a halation preventing agent, a storage stabilizing agent, a defoaming agent, and a shape improving agent. Specific examples thereof include 4-hydroxy-4'-methylchalkone.

The total amount of the optional component (D) is 0 to 99% by mass of the solid component, preferably 0 to 49% by mass, more preferably 0 to 10% by mass, even more preferably 0 to 5% by mass, much more preferably 0% by mass.

The ratio of resist base material (A)/optically active diazonaphthoquinone compound (B)/optional component (D) in the radiation-sensitive composition of the present embodiment is preferably 1 to 99/99 to 1/0 to 98% by mass based on solid matter, more preferably 5 to 95/95 to 5/0 to 49% by mass, even more preferably 10 to 90/90 to 10/0 to 10% by mass, much more preferably 20 to 80/80 to 20/0 to 5% by mass, and further preferably 25 to 75/75 to 25/0% by mass. The content ratio of each component is selected from each range so that the summation thereof is 100% by mass. By the above content ratio, there is a tendency that in addition to roughness, performance such as sensitivity and resolution is excellent.

The radiation-sensitive composition of the present embodiment can contain a resin within the range of not inhibiting the purpose of the present embodiment. Examples of the resin include, but not limited to, a novolac resin, polyvinyl phenols, polyacrylic acid, polyvinyl alcohol, a styrene-maleic anhydride resin, and a polymer containing acrylic acid, vinyl alcohol or vinylphenol as a monomeric unit, or derivative thereof. The content of the resin is arbitrarily adjusted according to the kind of the compound represented by the formula (1) to be used, is preferably 30 parts by mass or less per 100 parts by mass of the compound represented by the formula (1), more preferably 10 parts by mass or less, still more preferably 5 parts by mass or less, and particularly preferably 0 part by mass.

### (Resist Pattern Formation Method)

A resist pattern formation method according to the present embodiment comprises the steps of forming a resist film on a substrate using the radiation-sensitive composition of the present embodiment; exposing the resist film; and developing the exposed resist film. The resist pattern obtained by the resist pattern formation method of the present embodiment can be formed as an upper layer resist in a multilayer process.

In order to form a resist pattern, for example, a resist film is formed by coating a conventionally publicly known substrate with the radiation-sensitive composition of the present embodiment using a coating means such as spin coating, flow casting coating, and roll coating. The conventionally publically known substrate is not particularly limited. For example, a substrate for electronic components, and the one having a predetermined wiring pattern formed thereon, or the like can be exemplified. More specific examples include a substrate made of a metal such as a silicon wafer, copper, chromium, iron and aluminum, and a glass substrate. Examples of a wiring pattern material include, but not limited to, copper, aluminum, nickel, and gold. Also if required, the substrate may be a substrate having an inorganic and/or organic film provided thereon. Examples of the inorganic film include an inorganic antireflection film (inorganic BARC). Examples of the organic film include an organic antireflection film (organic BARC). Surface treatment with hexamethylene disilazane or the like may be conducted.

Next, the coated substrate is heated if required. The heating conditions vary according to the content composition of the radiation-sensitive composition, or the like, but are preferably 20 to 250°C, and more preferably 20 to 150°C. By heating, the adhesiveness of a resist to a substrate may improve, which is preferable. Then, the resist film is exposed to a desired pattern by any radiation selected from the group consisting of visible light, ultraviolet, excimer laser, electron beam, extreme ultraviolet (EUV), X-ray, and ion beam. The exposure conditions or the like are arbitrarily selected according to the compounding composition of the radiation-sensitive composition, or the like. In the present embodiment, in order to stably form a fine pattern with a high degree of accuracy in exposure, the resist film is preferably heated after radiation irradiation. The heating conditions vary according to the compounding composition of the radiation-sensitive composition, or the like, but are preferably 20 to 250°C, and more preferably 20 to 150°C.

Next, by developing the exposed resist film in a developing solution, a predetermined resist pattern is formed. As the developing solution, a solvent having a solubility parameter (SP value) close to the resist base material of the formula (1) used is preferably selected. A polar solvent such as a ketone-based solvent, an ester-based solvent, an alcohol-based solvent, an amide-based solvent, and an ether-based solvent; a hydrocarbon-based solvent; or an alkaline aqueous solution can be used.

Examples of the ketone-based solvent include, but not limited to, 1-octanone, 2-octanone, 1-nonanone, 2-nonanone, acetone, 4-heptanone, 1-hexanone, 2-hexanone, diisobutyl ketone, cyclohexanone, methylcyclohexanone, phenylacetone, methyl ethyl ketone, methyl isobutyl ketone, acetylacetone, acetonylacetone, ionone, diacetonyl alcohol, acetyl carbinol, acetophenone, methyl naphthyl ketone, isophorone, and propylene carbonate.

Examples of the ester-based solvent include, but not limited to, methyl acetate, butyl acetate, ethyl acetate, isopropyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, methyl formate, ethyl formate, butyl formate, propyl formate, ethyl lactate, butyl lactate, and propyl lactate.

Examples of the alcohol-based solvent include, but not limited to, an alcohol such as methyl alcohol, ethyl alcohol, n-propyl alcohol, isopropyl alcohol (2-propanol), n-butyl alcohol, sec-butyl alcohol, tert-butyl alcohol, isobutyl alcohol, n-hexyl alcohol, 4-methyl-2-pentanol, n-heptyl alcohol, n-octyl alcohol, and n-decanol; a glycol-based solvent such as ethylene glycol, diethylene glycol, and triethylene glycol; and a glycol ether-based solvent such as ethylene glycol monomethyl ether, propylene glycol monomethyl ether, ethylene glycol monoethyl ether, propylene glycol monoethyl ether, diethylene glycol monomethyl ether, triethylene glycol monoethyl ether, and methoxymethyl butanol.

Examples of the ether-based solvent include, but not limited to, dioxane and tetrahydrofuran in addition to the above glycol ether-based solvents.

Examples of the amide-based solvent which can be used include, but not limited to, N-methyl-2-pyrrolidone, N,N-dimethylacetamide, N,N-dimethylformamide, phosphoric hexamethyltriamide, and 1,3-dimethyl-2-imidazolidinone.

Examples of the hydrocarbon-based solvent include, but not limited to, an aromatic hydrocarbon-based solvent such as toluene and xylene, and an aliphatic hydrocarbon-based solvent such as pentane, hexane, octane, and decane.

In case of the above solvents, a plurality of these solvents may be mixed, or the solvent may be used by mixing the solvent with a solvent other than those described above or water within the range having performance. From the viewpoint of sufficiently securing the effects of the present embodiment, the water content ratio as the whole developing solution is preferably less than 70% by mass, more preferably less than 50% by mass, still more preferably less than 30% by mass, and much more preferably less than 10% by mass, and further preferably, water is substantially absent. Specifically, the content of the organic solvent in the developing solution is preferably 30% by mass or more and 100% by mass or less based on the total amount of the developing solution, more preferably 50% by mass or more and 100% by mass or less, still more preferably 70% by mass or more and 100% by mass or less, much more preferably 90% by mass or more and 100% by mass or less, and further preferably 95% by mass or more and 100% by mass or less.

Examples of the alkaline aqueous solution include, but not limited to, an alkaline compound such as mono-, di- or tri-alkylamines, mono-, di- or tri-alkanolamines, heterocyclic amines, tetramethyl ammonium hydroxide (TMAH), and choline.

Particularly, the developing solution is preferably a developing solution containing at least one kind of solvent selected from a ketone-based solvent, an ester-based solvent, an alcohol-based solvent, an amide-based solvent, and an ether-based solvent because the resist performance such as resolution and roughness of the resist pattern is improved.

The vapor pressure of the developing solution is preferably 5 kPa or less at 20°C, more preferably 3 kPa or less, and much more preferably 2 kPa or less. The evaporation of the developing solution on the substrate or in a developing cup is inhibited by setting the vapor pressure of the developing solution to 5 kPa or less, to improve temperature uniformity within a wafer surface, there is a tendency to resulting in improvement in size uniformity within the wafer surface.

Specific examples of the developing solution having a vapor pressure of 5 kPa or less include, but not limited to, a ketone-based solvent such as 1-octanone, 2-octanone, 1-nonanone, 2-nonanone, 4-heptanone, 2-hexanone, diisobutyl ketone, cyclohexanone, methylcyclohexanone, phenylacetone, and methyl isobutyl ketone, an ester-based solvent such as butyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxy propionate, 3-methoxy butyl acetate, 3-methyl-3-methoxy butyl acetate, butyl formate, propyl formate, ethyl lactate, butyl lactate, and propyl lactate, an alcohol-based solvent such as n-propyl alcohol, isopropyl alcohol, n-butyl alcohol, sec-butyl alcohol, tert-butyl alcohol, isobutyl alcohol, n-hexyl alcohol, 4-methyl-2-pentanol, n-heptyl alcohol, n-octyl alcohol, and n-decanol, a glycol-based solvent such as ethylene glycol, diethylene glycol, and triethylene glycol; a glycol ether-based solvent such as ethylene glycol monomethyl ether, propylene glycol monomethyl ether, ethylene glycol monoethyl ether, propylene glycol monoethyl ether, diethylene glycol monomethyl ether, triethylene glycol monoethyl ether, and methoxymethyl butanol, an ether-based solvent such as tetrahydrofuran, an amide-based solvent such as N-methyl-2-pyrrolidone, N,N-dimethylacetamide, and N,N-dimethylformamide, an aromatic hydrocarbon-based solvent such as toluene and xylene, and an aliphatic hydrocarbon-based solvent such as octane and decane.

Specific examples of the developing solution having a vapor pressure of 2 kPa or less include, but not limited to, a ketone-based solvent such as 1-octanone, 2-octanone, 1-nonanone, 2-nonanone, 4-heptanone, 2-hexanone, diisobutyl ketone, cyclohexanone, methylcyclohexanone, and phenylacetone, an ester-based solvent such as butyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxy propionate, 3-methoxy butyl acetate, 3-methyl-3-methoxy butyl acetate, ethyl lactate, butyl lactate, and propyl lactate, an alcohol-based solvent such as n-butyl alcohol, sec-butyl alcohol, tert-butyl alcohol, isobutyl alcohol, n-hexyl alcohol, 4-methyl-2-pentanol, n-heptyl alcohol, n-octyl alcohol, and n-decanol, a glycol-based solvent such as ethylene glycol, diethylene glycol, and triethylene glycol, a glycol ether-based solvent such as ethylene glycol monomethyl ether, propylene glycol monomethyl ether, ethylene glycol monoethyl ether, propylene glycol monoethyl ether, diethylene glycol monomethyl ether, triethylene glycol monoethyl ether, and methoxymethyl butanol, an amide-based solvent such as N-methyl-2-pyrrolidone, N,N-dimethylacetamide, and N,N-dimethylformamide, an aromatic hydrocarbon-based solvent such as xylene, and an aliphatic hydrocarbon-based solvent such as octane and decane.

To the developing solution, a surfactant can be added in an appropriate amount, if required. The surfactant is not particularly limited but, for example, an ionic or nonionic fluorine-based and/or silicon-based surfactant can be used. Examples of the fluorine-based and/or silicon-based surfactant include the surfactants described in Japanese Patent Application Laid-Open Nos. 62-36663, 61-226746, 61-226745, 62-170950, 63-34540, 7-230165, 8-62834, 9-54432, and 9-5988, and U.S. Pat. Nos. 5,405,720, 5,360,692, 5,529,881, 5,296,330, 5,436,098, 5,576,143, 5,294,511, and 5,824,451. The surfactant is preferably a nonionic surfactant. The nonionic surfactant is not particularly limited, but a fluorine-based surfactant or a silicon-based surfactant is more preferably used.

The amount of the surfactant used is, but not limited to, usually 0.001 to 5% by mass based on the total amount of the developing solution, preferably 0.005 to 2% by mass, and more preferably 0.01 to 0.5% by mass.

The development method is, but not limited to, for example, a method for dipping a substrate in a bath filled with a developing solution for a fixed time (dipping method), a method for raising a developing solution on a substrate surface by the effect of a surface tension and keeping it still for a fixed time, thereby conducting the development (puddle method), a method for spraying a developing solution on a substrate surface (spraying method), and a method for continuously ejecting a developing solution on a substrate rotating at a constant speed while scanning a developing solution ejecting nozzle at a constant rate (dynamic dispense method), or the like may be applied. The time for conducting the pattern development is not particularly limited, but is preferably 10 seconds to 90 seconds.

After the step of conducting development, a step of stopping the development by the replacement with another solvent may be practiced.

A step of rinsing the resist film with a rinsing solution containing an organic solvent is preferably practiced after the development.

The rinsing solution used in the rinsing step after development is not particularly limited as long as the rinsing solution does not dissolve the formed resist pattern. A solution containing a general organic solvent or water may be used as the rinsing solution. As the rinsing solution, a rinsing solution containing at least one kind of organic solvent selected from a hydrocarbon-based solvent, a ketone-based solvent, an ester-based solvent, an alcohol-based solvent, an amide-based solvent, and an ether-based solvent is preferably used. More preferably, after development, a step of rinsing the film by using a rinsing solution containing at least one kind of organic solvent selected from the group consisting of a ketone-based solvent, an ester-based solvent, an alcohol-based solvent and an amide-based solvent is conducted. Still more preferably, after development, a step of rinsing the film by using a rinsing solution containing an alcohol-based solvent or an ester-based solvent is conducted. Still yet more preferably, after development, a step of rinsing the film by using a rinsing solution containing a monohydric alcohol is conducted. Further preferably, after development, a step of rinsing the film by using a rinsing solution containing a monohydric alcohol having 5 or more carbon atoms is conducted. The time for rinsing the pattern is not particularly limited, but is preferably 10 seconds to 90 seconds.

Herein, examples of the monohydric alcohol used in the rinsing step after development include a linear, branched or cyclic monohydric alcohol. Specifically, 1-butanol, 2-butanol, 3-methyl-1-butanol, tert-butyl alcohol, 1-pentanol, 2-pentanol, 1-hexanol, 4-methyl-2-pentanol, 1-heptanol, 1-octanol, 2-hexanol, cyclopentanol, 2-heptanol, 2-octanol, 3-hexanol, 3-heptanol, 3-octanol, and 4-octanol or the like can be used without limitations. Preferably, a monohydric alcohol having 5 or more carbon atoms can be used. As a specific example thereof, 1-hexanol, 2-hexanol, 4-methyl-2-pentanol, 1-pentanol, and 3-methyl-1-butanol or the like can be used.

A plurality of these components may be mixed, or the component may be used by mixing the component with an organic solvent other than those described above.

The water content ratio in the rinsing solution is preferably 10% by mass or less, more preferably 5% by mass or less, and still more preferably 3% by mass or less. By setting the water content ratio to 10% by mass or less, there is a tendency that better development characteristics can be obtained.

The vapor pressure at 20°C of the rinsing solution used after development is preferably 0.05 kPa or more and 5 kPa or less, more preferably 0.1 kPa or more and 5 kPa or less, and much more preferably 0.12 kPa or more and 3 kPa or less. By setting the vapor pressure of the rinsing solution to 0.05 kPa or more and 5 kPa or less, the temperature uniformity in the wafer surface is further enhanced, moreover, swelling due to permeation of the rinsing solution is further inhibited, and there is a tendancy to resulting in further improving in the dimensional uniformity in the wafer surface.

The rinsing solution may also be used after adding an appropriate amount of a surfactant to the rinsing solution.

In the rinsing step, the wafer after development is rinsed using the organic solvent-containing rinsing solution. The method for rinsing treatment is not particularly limited. However, for example, a method for continuously ejecting a rinsing solution on a substrate spinning at a constant speed (spin coating method), a method for dipping a substrate in a bath filled with a rinsing solution for a fixed time (dipping method), and a method for spraying a rinsing solution on a substrate surface (spraying method), or the like can be applied. Above all, it is preferable to conduct the rinsing treatment by the spin coating method and after the rinsing, spin the substrate at a rotational speed of 2,000 rpm to 4,000 rpm, to remove the rinsing solution from the substrate surface.

After forming the resist pattern, a pattern wiring substrate is obtained by etching. Etching can be conducted by a publicly known method such as dry etching using plasma gas, and wet etching with an alkaline solution, a cupric chloride solution, and a ferric chloride solution or the like.

After forming the resist pattern, plating can also be conducted. Examples of the above plating method include, but not limited to, copper plating, solder plating, nickel plating, and gold plating.

The remaining resist pattern after etching can be peeled by an organic solvent. Examples of the above organic solvent include, but not limited to, PGMEA (propylene glycol monomethyl ether acetate), PGME (propylene glycol monomethyl ether), and EL (ethyl lactate). Examples of the above peeling method include, but not limited to, a dipping method and a spraying method. A wiring substrate having a resist pattern formed thereon may be a multilayer wiring substrate, and may have a small diameter through hole.

The wiring substrate obtained in the present embodiment can also be formed by a method for forming a resist pattern, then depositing a metal in vacuum, and subsequently dissolving the resist pattern in a solution, i.e., a liftoff method.

### Examples

The present embodiment will be more specifically described with reference to examples below. In Examples and Comparative Examples below, the structures of compounds were confirmed by ¹H-NMR measurement.

### Synthesis Example 1 (Synthesis of CR-1 (resist base material (A)))

Under a nitrogen gas stream, resorcinol manufactured by Kanto Chemical Co., Inc. (22 g, 0.2 mol), 4-iodobenzaldehyde (46.4 g, 0.2 mol), and dehydrated ethanol (200 mL) were charged to a four necked flask (1000 mL) sufficiently dried, substituted with nitrogen, and equipped with a dropping funnel, a Dimroth condenser tube, a thermometer, and a stirring blade, to prepare an ethanol solution. This solution was heated to 85°C by a mantle heater with stirring. Subsequently, 75 mL of concentrated sulfuric acid (35%) was dropped through the dropping funnel for 30 minutes, followed by stirring at 85°C for 3 hours. After the reaction terminated, it was stood to cool, and after it reached room temperature, it was cooled in an ice bath. It was left at rest for 1 hour, to produce a light yellow crude crystal, which was filtered. The crude crystal was washed twice with 500 mL of methanol, filtered and dried in a vacuum to obtain 44.0 g of a compound.

As a result of LC-MS analysis, this compound exhibited a molecular weight of 1296. Specifically, the molecular weight was measured using Acquity UPLC/MALDI-Synapt HDMS manufactured by Waters Corp. The chemical shift value of ¹H-NMR in a deuterated dimethyl sulfoxide solvent (δ ppm, TMS standard) was 5.5 (s, 4H), 6.0 to 6.8 (m, 24H), and 8.4 to 8.5 (d, 8H).

From these results, the obtained compound was identified as the target compound (CR-1) (yield: 64%).

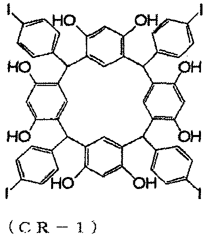

### Synthesis Example 1B (Synthesis of CR-1A)

74.3 g (3.71 mol) of anhydrous HF and 50.5 g (0.744 mol) of BF₃ were charged into a temperature-controllable autoclave (made of SUS316L) having an internal capacity of 500 mL and equipped with an electromagnetic stirring device. The content was stirred and increased in pressure with carbon monoxide to 2 MPa while maintaining the liquid temperature to -30°C. Thereafter, while maintaining the pressure to 2 MPa and the liquid temperature to -30°C, a raw material obtained by mixing 57.0 g (0.248 mol) of 4-cyclohexylbenzene and 50.0 g of n-heptane was fed thereto, and maintained the content for 1 hour. Then, the content was collected into ice, diluted with benzene, and neutralized to provide an oily layer, which was analyzed by gas chromatograph for evaluating the reaction performance. As a result, the 4-cyclohexylbenzene conversion was 100%, and the 4-cyclohexylbenzaldehyde selectivity was 97.3%.

The target component was isolated by simple distillation and analyzed by GC-MS, and the result exhibited a molecular weight of 188, which was 4-cyclohexylbenzaldehyde (hereinafter, referred to as CHBAL) of a target object. Specifically, the molecular weight was measured using GC-MS QP2010 Ultra manufactured by Shimadzu Corp. The chemical shift value of ¹H-NMR in a deuterated chloroform solvent (δ ppm, TMS standard) was 1.0 to 1.6 (m, 10H), 2.6 (m, 1H), 7.4 (d, 2H), 7.8 (d, 2H), and 10.0 (s, 1H).

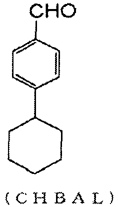

Under a nitrogen gas stream, resorcinol manufactured by Kanto Chemical Co., Inc. (22 g, 0.2 mol), the 4-cyclohexylbenzaldehyde (46.0 g, 0.2 mol), and dehydrated ethanol (200 mL) were charged to a four necked flask (1000 mL) sufficiently dried, substituted with nitrogen, and equipped with a dropping funnel, a Dimroth condenser tube, a thermometer, and a stirring blade, to prepare an ethanol solution. This solution was heated to 85°C by a mantle heater with stirring. Subsequently, 75 mL of concentrated sulfuric acid (35%) was dropped through the dropping funnel for 30 minutes, followed by stirring at 85°C for 3 hours. After the reaction terminated, it was stood to cool, and after it reached room temperature, it was cooled in an ice bath. It was left at rest for 1 hour, to produce a target light yellow crude crystal, which was filtered. The crude crystal was washed twice with 500 mL of methanol, filtered and dried in a vacuum to obtain 50 g of a product (hereinafter, referred to as CR-1A).

As a result of LC-MS analysis, the structure of this product exhibited a molecular weight of 1121. The chemical shift value of ¹H-NMR in a deuterated chloroform solvent (δ ppm, TMS standard) was 0.8 to 1.9 (m, 44H), 5.5 and 5.6 (d, 4H), 6.0 to 6.8 (m, 24H), and 8.4 and 8.5 (m, 8H).

From these results, the obtained product was identified as the target compound (CR-1A) (yield: 91%).

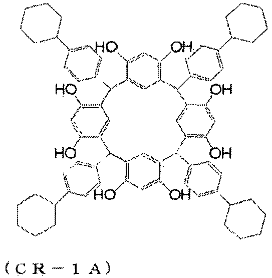

### Examples 1 to 8 and Comparative Examples 1 to 4 (2) Evaluation of Resist Performance

Components were prepared as described in Table 1 to obtain a homogenous solution. Then, it was filtered through a membrane filter made of Teflon(R) with a pore diameter of 0.1 µm to prepare a radiation-sensitive composition. Each radiation-sensitive composition was evaluated.

**[Table 1]**

| | Resist base material (A) | Optically active compound (B) | Solvent |
|---|---|---|---|
| | (g) | (g) | (g) |
| Example 1 | CR-1 | P-1 | S-1 |
| | 0.25 | 1.75 | 30.0 |
| Example 2 | CR-1 | P-1 | S-1 |
| | 0.5 | 1.5 | 30.0 |
| Example 3 | CR-1 | P-1 | S-1 |
| | 0.75 | 1.25 | 30.0 |
| Example 4 | CR-1 | P-2 | S-1 |
| | 0.5 | 1.5 | 30.0 |
| Example 5 | CR-1 | P-3 | S-1 |
| | 0.5 | 1.5 | 30.0 |
| Example 6 | CR-1 | P-4 | S-1 |
| | 0.5 | 1.5 | 30.0 |
| Example 7 | CR-1A | P-1 | S-1 |
| | 0.5 | 1.5 | 30.0 |
| Example 8 | CR-1 | P-1 | S-1 |
| | 0.5 | 1.5 | 6.0 |
| Comparative Example 1 | CR-1 | P-1 | S-1 |
| | 2.0 | 0 | 30.0 |
| Comparative Example 2 | CR-1 | P-1 | S-1 |
| | 0.5 | 1.5 | 250.0 |
| Comparative Example 3 | CR-1 | P-1 | S-1 |
| | 0.5 | 1.5 | 0.4 |
| Comparative Example 4 | PHS-1 | P-1 | S-1 |
| | 0.5 | 1.5 | 30.0 |

The following was used as the resist base material (A).
PHS-1: polyhydroxystyrene (Mw = 8000) (Sigma-Aldrich Co., LLC)

The following was used as the optically active compound (B).
P-1: naphthoquinonediazide-based photosensitizing agent of the following chemical structural formula (G) (4NT-300, Toyo Gosei Co., Ltd.)
P-2: naphthoquinonediazide-based photosensitizing agent of the chemical structural formula (G-1) (TS-200, Sanbo Chemical Ind., Ltd.)
P-3: naphthoquinonediazide-based photosensitizing agent of the chemical structural formula (G-2) (TKE1-510, Sanbo Chemical Ind., Ltd.)
P-4: naphthoquinonediazide-based photosensitizing agent of the chemical structural formula (G-3) (PQ-614, Sanbo Chemical Ind., Ltd.)

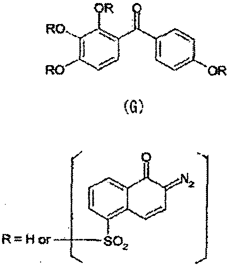

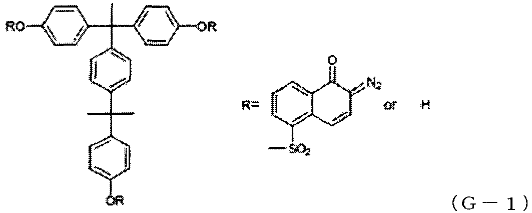

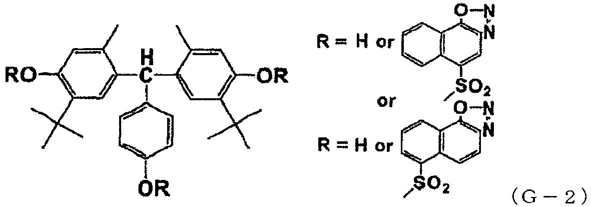

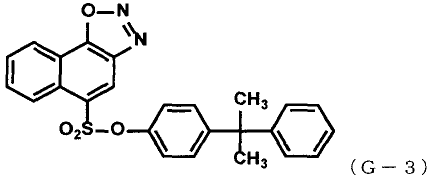

The following was used as the solvent.
S-1: propylene glycol monomethyl ether (Tokyo Kasei Kogyo Co., Ltd.)

A clean silicon wafer was spin coated with a radiation-sensitive composition, and then prebaked (PB) before exposure in an oven of 110°C to form a resist film with a thickness of 200 nm. The resist film was exposed to ultraviolet using an ultraviolet exposure apparatus (mask aligner MA-10 manufactured by Mikasa Co., Ltd.). The ultraviolet lamp used was a super high pressure mercury lamp (relative intensity ratio: g-ray:h-ray:i-ray:j-ray = 100:80:90:60). After irradiation, it was heated at 110°C for 90 seconds, and immersed in 2.38% by weight tetramethylammonium hydroxide (TMAH) alkaline developing solution for 60 seconds for development. Subsequently, it was washed with ultrapure water for 30 seconds, and dried to form a 5 µm positive type resist pattern.

The obtained line and space were observed by a scanning electron microscope (S-4800 manufactured by Hitachi High-Technologies Corporation). Line edge roughness was evaluated as "excellent" when the pattern had less than 10 nm of roughness, as "good" when the pattern had 10 nm or more and less than 100 nm of roughness, and as "poor" when the pattern had more than 100 nm of roughness.

The resists of Examples 1 to 8 were able to obtain a good resist pattern having resolution of 5 µm. In addition, the pattern had small roughness and was excellent.

The resists of Comparative Examples 2 and 3 were unable to obtain a good resist pattern having resolution of 5 µm.

The resists of Comparative Examples 1 and 4 were able to obtain a good resist pattern having resolution of 5 µm. However, the pattern had large roughness and was poor.

As described above, the radiation-sensitives composition of Examples can form a resist pattern having small roughness and a good shape as compared with the radiation-sensitive compositions of Comparative Examples. Compounds other than those described in Examples produce similar effects as long as the above conditions of the present embodiment are satisfied.

This application is based on Japanese Patent Application No. 2015-070125 filed with JPO on March 30, 2015, the entire contents of which are hereby incorporated by reference.

### Industrial Applicability

The present invention can provide a radiation-sensitive composition which comprises a compound represented by a specific chemical structural formula and is useful as a resist material. The radiation-sensitive composition is useful as a non-chemical amplification low molecular weight resist material and is suitably used in resist pattern formation.

## Claims

1. A radiation-sensitive composition comprising (A) a resist base material, (B) an optically active diazonaphthoquinone compound, and (C) a solvent, wherein
in the radiation-sensitive composition, the content of a solid component is 1 to 80% by mass, the content of the solvent is 20 to 99% by mass, and
the resist base material (A) is a compound represented by the formula (1): 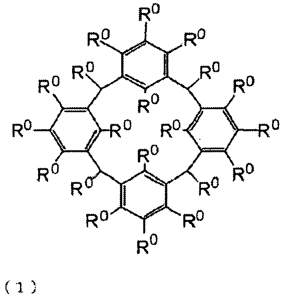 wherein R⁰ are each independently a hydrogen atom, a hydroxyl group, a cyano group, a nitro group, a heterocyclic group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, a substituted or unsubstituted aralkyl group of 7 to 30 carbon atoms, a substituted or unsubstituted alkoxy group of 1 to 20 carbon atoms, a substituted or unsubstituted amino group of 0 to 20 carbon atoms, a substituted or unsubstituted alkenyl group of 1 to 20 carbon atoms, a substituted or unsubstituted acyl group of 1 to 20 carbon atoms, a substituted or unsubstituted alkoxycarbonyl group of 2 to 20 carbon atoms, a substituted or unsubstituted alkyloyloxy group of 1 to 20 carbon atoms, a substituted or unsubstituted aryloyloxy group of 7 to 30 carbon atoms, a substituted or unsubstituted alkylsilyl group of 1 to 20 carbon atoms, or any of these groups bonded to a divalent group, wherein the divalent group is a group selected from the group consisting of a substituted or unsubstituted alkylene group, a substituted or unsubstituted arylene group, and an ether group.

2. The radiation-sensitive composition according to claim 1, wherein at least one of R⁰ in the compound represented by the formula (1) is a monovalent group containing an iodine atom.

3. The radiation-sensitive composition according to claim 2, wherein the compound represented by the formula (1) is a compound represented by the formula (2): 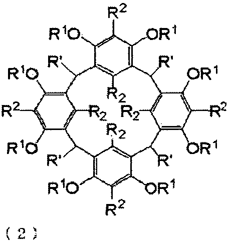 wherein R¹ are each independently a hydrogen atom, a cyano group, a nitro group, a heterocyclic group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, or a substituted or unsubstituted alkylsilyl group of 1 to 20 carbon atoms; R² are each independently a hydrogen atom, a cyano group, a nitro group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, a substituted or unsubstituted aralkyl group of 7 to 30 carbon atoms, a substituted or unsubstituted alkoxy group of 1 to 20 carbon atoms, a substituted or unsubstituted alkenyl group of 1 to 20 carbon atoms, a substituted or unsubstituted acyl group of 1 to 20 carbon atoms, a substituted or unsubstituted alkoxycarbonyl group of 2 to 20 carbon atoms, a substituted or unsubstituted alkyloyloxy group of 1 to 20 carbon atoms, a substituted or unsubstituted aryloyloxy group of 7 to 30 carbon atoms, or a substituted or unsubstituted alkylsilyl group of 1 to 20 carbon atoms; and R' are each independently a hydrogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, or a group represented by the formula (3) : 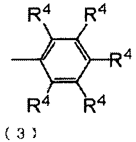 wherein R⁴ are each independently a hydrogen atom, a cyano group, a nitro group, a heterocyclic group, a halogen atom, a substituted or unsubstituted linear aliphatic hydrocarbon group of 1 to 20 carbon atoms, a substituted or unsubstituted branched aliphatic hydrocarbon group of 3 to 20 carbon atoms, a substituted or unsubstituted cyclic aliphatic hydrocarbon group of 3 to 20 carbon atoms, a substituted or unsubstituted aryl group of 6 to 20 carbon atoms, a substituted or unsubstituted alkoxy group of 1 to 20 carbon atoms, or a substituted or unsubstituted alkylsilyl group of 1 to 20 carbon atoms, wherein at least one R² and/or at least one R⁴ is a monovalent group containing an iodine atom.

4. The radiation-sensitive composition according to claim 3, wherein the compound represented by the formula (2) is a compound represented by the formula (4): 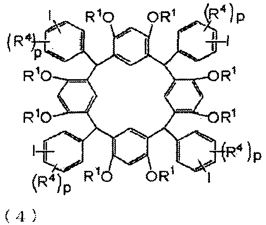 wherein R¹ and R⁴ are as defined above; and p is an integer of 0 to 4.

5. The radiation-sensitive composition according to any one of claims 1 to 4, wherein the solid component contains resist base material (A)/optically active diazonaphthoquinone compound (B)/optional component (D) at 1 to 99/99 to 1/0 to 98% by mass based on the solid component.

6. The radiation-sensitive composition according to any one of claims 1 to 5, wherein the radiation-sensitive composition is capable of forming an amorphous film by spin coating.

7. The radiation-sensitive composition according to claim 6, wherein the dissolution rate of the amorphous film in a developing solution at 23°C is 5 angstrom/sec or less.

8. The radiation-sensitive composition according to claim 7, wherein the dissolution rate of the amorphous film irradiated with g-ray, h-ray, i-ray, KrF excimer laser, ArF excimer laser, extreme ultraviolet, electron beam, or X-ray or the amorphous film heated at 20 to 500°C in a developing solution is 10 angstrom/sec or more.

9. An amorphous film obtained from the radiation-sensitive composition according to any one of claims 1 to 5.

10. A method for forming a resist pattern, comprising the steps of:
coating a substrate with the radiation-sensitive composition according to any one of claims 1 to 8, thereby forming a resist film;
exposing the resist film; and
developing the exposed resist film.
